(19) Europäisches Patentamt

European Patent Office

Office européen des brevets

(11) **EP 0 821 425 B1**

(12) **EUROPEAN PATENT SPECIFICATION**

(45) Date of publication and mention
of the grant of the patent:
**31.05.2006 Bulletin 2006/22**

(51) Int Cl.:
*H01L 27/085* (2006.01)     *H01L 27/06* (2006.01)
*H01P 1/15* (2006.01)

(21) Application number: **97112558.8**

(22) Date of filing: **22.07.1997**

(54) **A semiconductor device having a semiconductor switch structure**

Halbleiteranordnung in Halbleiter-Schaltungsstruktur

Dispositif semi-conducteur ayant une structure de commutation à semi-conducteurs

(84) Designated Contracting States:
**DE FR GB**

(30) Priority: **24.07.1996   JP 19487696**

(43) Date of publication of application:
**28.01.1998   Bulletin 1998/05**

(73) Proprietor: **NEC CORPORATION**
**Tokyo (JP)**

(72) Inventor: **Mizutani, Hiroshi,**
**c/o NEC Corporation**
**Minato-ku,**
**Tokyo (JP)**

(74) Representative: **Baronetzky, Klaus**
**Splanemann Reitzner**
**Baronetzky Westendorp**
**Patentanwälte**
**Rumfordstrasse 7**
**80469 München (DE)**

(56) References cited:
**EP-A- 0 373 803**          **EP-A- 0 700 152**
**JP-A- 7 058 620**

• **PATENT ABSTRACTS OF JAPAN vol. 017, no. 706
(E-1483), 22 December 1993 (1993-12-22) -& JP 05
243872 A (HITACHI LTD), 21 September 1993
(1993-09-21)**
• **PATENT ABSTRACTS OF JAPAN vol. 016, no. 204
(E-1202), 15 May 1992 (1992-05-15) -& JP 04
032309 A (FUJITSU LTD), 4 February 1992
(1992-02-04)**

**Description**

BACKGROUNDS OF THE INVENTION

FIELD OF THE INVENTION

The present invention relates to a semiconductor device having a semiconductor switch structure that uses a transmission line such as a micro striped line comprising a metallic conductor and a field effect transistor.

DESCRIPTION OF THE RELATED ART

A semiconductor switch element using a field effect transistor (FET) may be expressed equivalently by resistance and capacitor. For example, an FET inserted into a transmission line is equivalent to resistance in ON status, while it becomes equivalent to capacitor in OFF status. As representative switch circuits using this kind of FET, there are, for example, a serial structure switch circuit wherein source and drain of FET 1901 are connected to an input terminal and an output terminal respectively as shown in FIG. 19, a parallel structure switch circuit wherein a source and drain of FET 2102 are connected to 2-line type transmission line respectively as shown in FIG. 21, a serial- parallel structure switch circuit which comprises FET 2301 and FET 2302 wherein the above serial structure and parallel structure are combined as shown in FIG. 23, a switch circuit that uses resonance between a serial FET 2501 and a coil 2502 parallelly connected thereto as shown in FIG. 25, and a switch circuit of a structure wherein λ/4 line 2702 is serially connected to a drain or a source of parallel connection FET 2701 as shown in FIG. 27.

In order to obtain large electric power in these switch circuits using FET, it is best to increase the gate width of FET. This in turn means to reduce the resistance value in an equivalent circuit of FET and increase the capacity value.

However, in each of the above switch circuits as the conventional semiconductor devices in the prior art, when gate width was increased so as to obtain large electric power, insertion loss or isolation that was determined by the resistance value and capacity value of FET was deteriorated in some cases, which has been a problem in the conventional semiconductor devices according to the prior art. This problem is explained more concretely hereinafter.

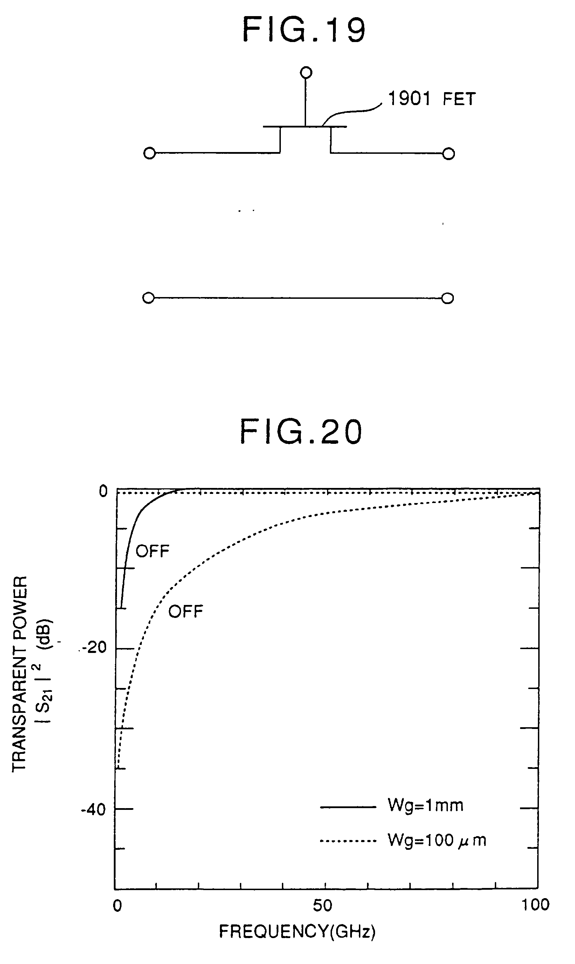

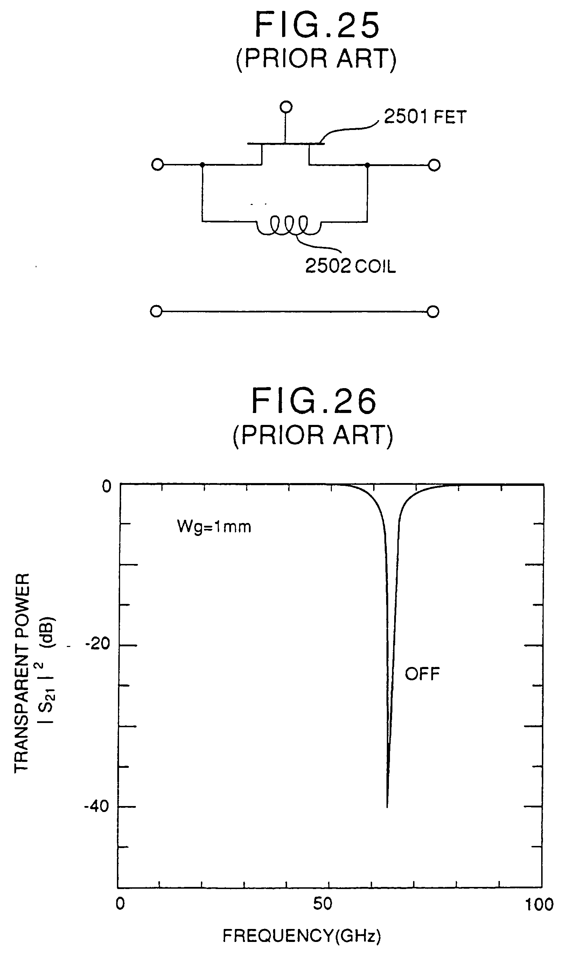

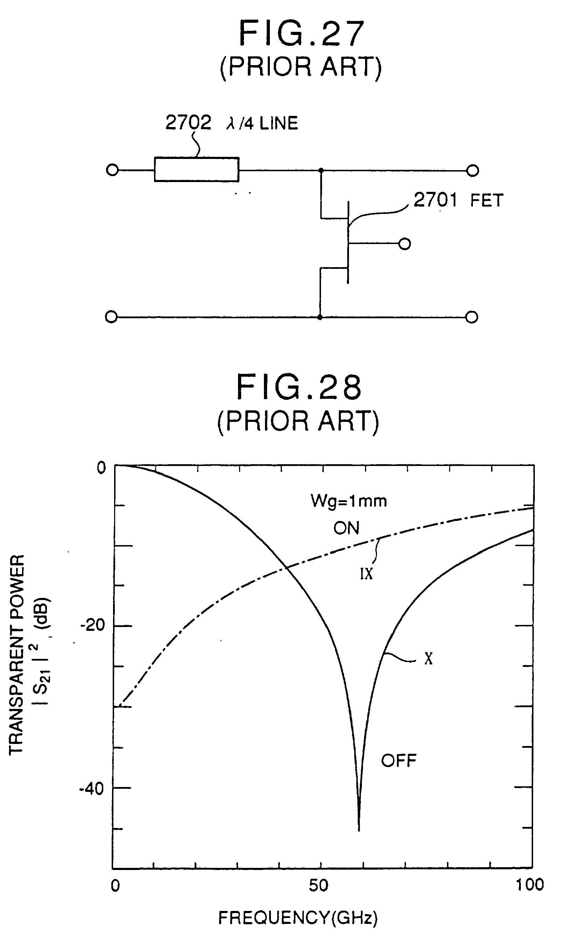

The transparent characteristics of each switch circuit in the case when the gate width Wg of FET 1901, 2101, 2301, 2302, 2501, and 2701 that structure respective switch circuits shown in FIG. 19, FIG. 21, FIG. 23. FIG. 25 and FIG. 27 is 100$\mu$m, and the case when that is 1 mm are shown in FIG. 20, FIG. 22, FIG. 24, FIG. 26 and FIG. 28. For example, the transparent characteristics of the serial structure switch circuit shown in FIG. 19 are shown in FIG. 20. In this FIG. 20, the characteristics of FET 1901 in the case when the gate width Wg is 1mm are represented by a solid line, while those in the case when the gate width Wg is 100 $\mu$m are represented by a dotted line. As shown in the figure, when the gate width Wg is 1 mm, the capacity value increases, as a result, the isolation, i.e., the power breaking capacity of switch at the moment when the switch is turned OFF decreases in comparison with the case when the gate width Wg is 100 $\mu$m.

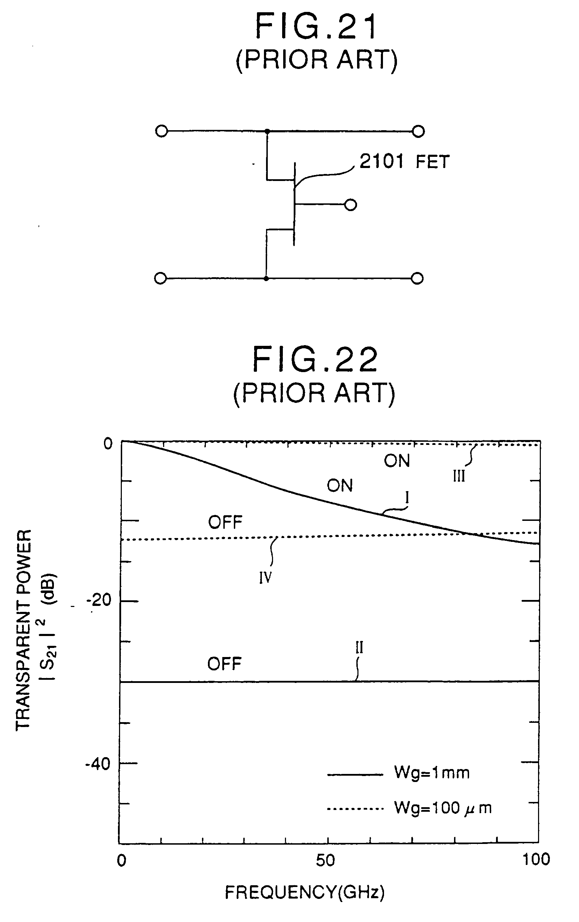

And, the transparent characteristics of a parallel structure switch circuit shown in FIG. 21 is shown in FIG. 22. In this FIG. 22 in turn, the characteristics of FET 2101 in the case when the gate width Wg is 1mm are represented by solid lines I and II, while those in the case when the gate width Wg is 100 $\mu$m are represented by dotted lines III and IV. In reference to FIG. 22, the isolation appears to increase in the case when the gate width is 1 mm (characteristics II) more than in the case when the gate width is 100 $\mu$m (characteristics IV). However, the insertion loss, i.e., the power loss of switch at the moment when the switch is turned ON increases in the case when the gate width is 1 mm (characteristics I) more than in the case when the gate width is 100 $\mu$m (characteristics III).

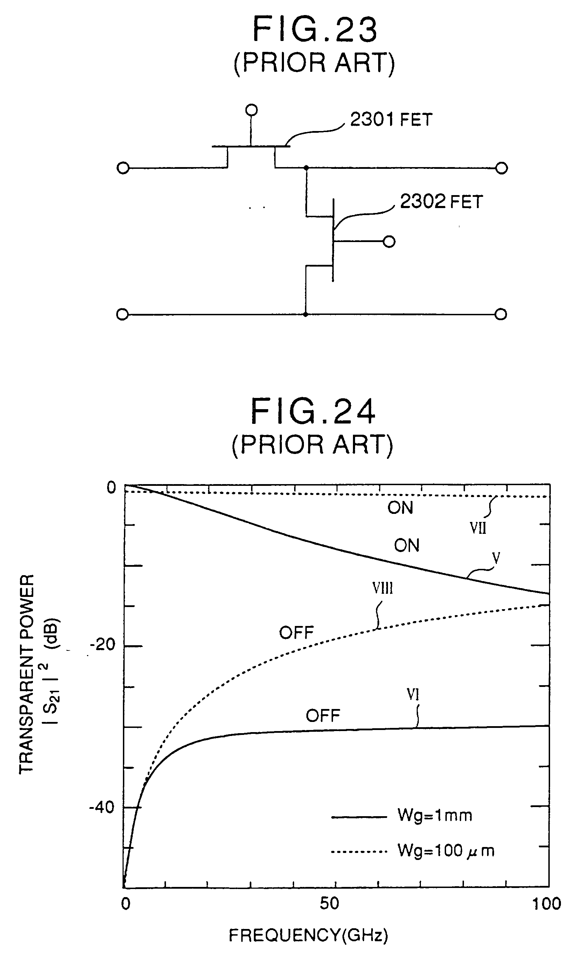

While, the transparent characteristics of a serial- parallel structure switch circuit shown in FIG. 23 are shown in FIG. 24. In this FIG. 24, the characteristics of FET 2302 in the case when the gate width Wg is 1 mm are represented by solid lines V and VI, while those in the case when the gate width Wg is 100 $\mu$m are represented by dotted lines VII and VIII. In reference to FIG. 24, the isolation changes according to the frequency as shown in characteristicsVI and characteristics VIII, but at the same frequency, the isolation increases in the case when the gate width is 1 mm (characteristic VI) more than in the case when the gate width is 100 $\mu$m (characteristics VIII). However, the insertion loss becomes larger in the case when the gate width is 1 mm (characteristics V) more than in the case when the gate width is 100 $\mu$m (characteristics VII).

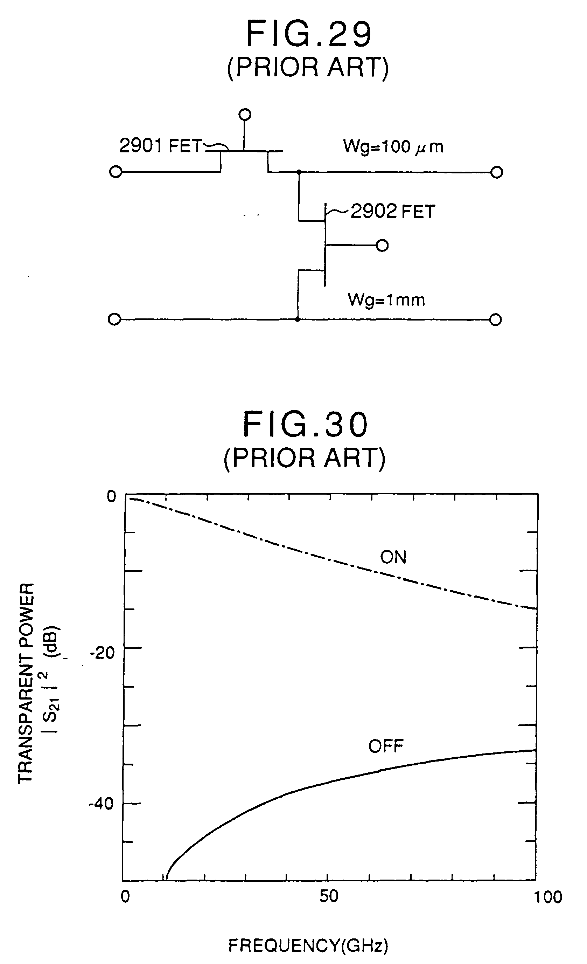

By the way, in the switch circuit of the serial-parallel structure in FIG. 23, the gate width of FET 2301 may differ from that of FET 2302. For example, as shown in FIG. 29, the transparent characteristics, both the isolation loss and the isolation, in the case when the gate width of FET 2301 is 100 $\mu$m and that of FET 2302 is 1 mm change according to the increase of the frequency as shown in FIG. 30. But, even in the case when FET having different width is used, the insertion loss becomes large.

Further, the transparent characteristics of a switch circuit of a structure that uses a serial FET 2501 and a coil 2502 shown in FIG. 25 are shown in FIG. 26. In this FIG. 26, the characteristics in the case when the gate width Wg of FET 2501 is 1 mm are represented by a solid line. As illustrated, though preferable insertion loss can be obtained locally, the range is very narrow because resonance is used.

And the transparent characteristics of a switch circuit having a structure of a parallel FET 2701 and a serial $\lambda$/4 line 2702 shown in FIG. 27 are shown in FIG. 28. In this FIG. 28, the characteristics in the case when the gate width Wg of FET 2701 is 1 mm are represented by a dashed line IX and a solid line X. As known from the characteristics X, the insertion loss at a high frequency band (60 GHz in this case) becomes large.

As mentioned in details in the above, it is difficult to obtain desired transparent characteristics in the conventional respective switch circuits according to the prior art. For instance, when the isolation loss is set at 1.5 dB and the isolation is set to 20 dB as the characteristic standards at the frequency band of 60 GHz, if the gate width Wg is set to 1 mm, the only circuit that satisfies the standards of isolation loss and isolation among the above conventional switch circuits is the circuit using the serial FET 2501 and a coil 2502 shown in FIG. 25. However, in the above switch circuit, as mentioned above, desired characteristics in insertion loss can be obtained only in an extremely narrow band.

As described heretofore, in the above respective switch circuits as semiconductor devices according to the prior art, there has been not any circuit structure that satisfies the requirement to increase the gate width of FET as a semiconductor switch element so as to obtain large power transmission, and the requirement to attain a low insertion loss and a high isolation especially at a high frequency and in a wide band at the same time, which has been the problem with the conventional semiconductor devices according to the prior art.

EP-A-373 803 discloses R.F. switching circuits with inter-digitated source and drain regions.

EP-A-700 152 discloses an Impedance matching circuit having a coupling line longer than 1/4 of a wavelength of the design center frequency

JP-A-05243872 discloses a gate electrode functioning as a distributed constant line.

<u>SUMMARY OF THE INVENTION</u>

Accordingly, an object of the present invention is to provide a semiconductor device that enables to satisfy the requirements to attain a low insertion loss and a high isolation, especially at a high frequency and at the same time in a wide band.

According to the invention, a semiconductor device having a semiconductor switch structure using a transmission line and a field effect transistor, is disclosed as claimed in claims 1-16.

Objects, features and advantages of the present invention will become clear from the detailed description given herebelow.

<u>BRIEF DESCRIPTION OF THE DRAWINGS</u>

The present invention will be understood more fully from the detailed description given herebelow and from the accompanying drawings of the preferred embodiment of the invention, which, however, should not be taken to be limitative to the invention, but are for explanation and understanding only.

In the drawings:

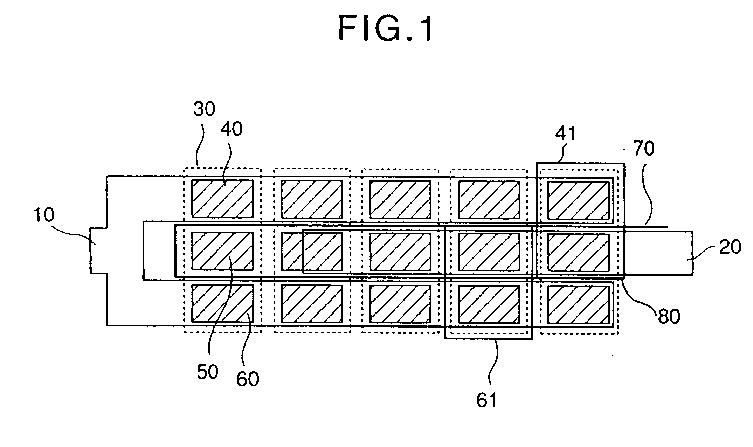

FIG. 1 is a top view showing a structure of a semiconductor device according to the first preferred embodiment under the present invention.

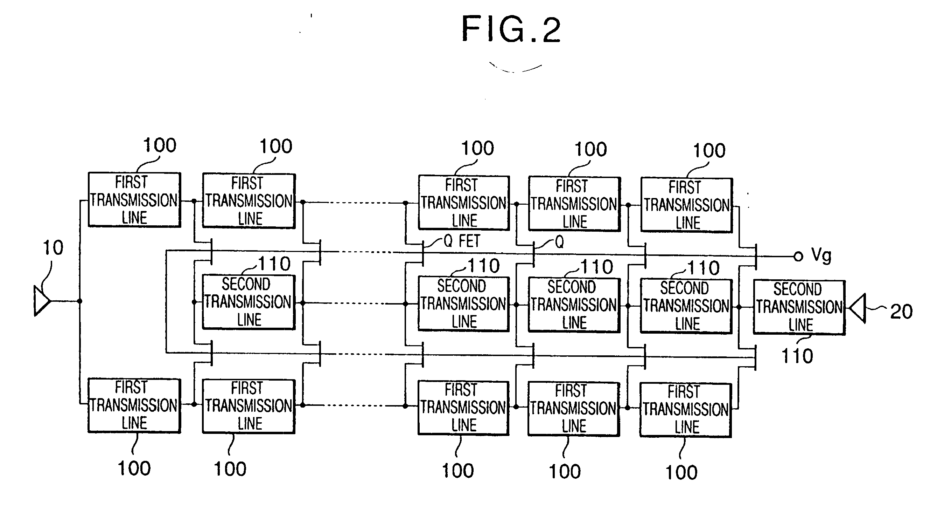

FIG. 2 is a top view showing a structure of a semiconductor device according to the second preferred embodiment under the present invention.

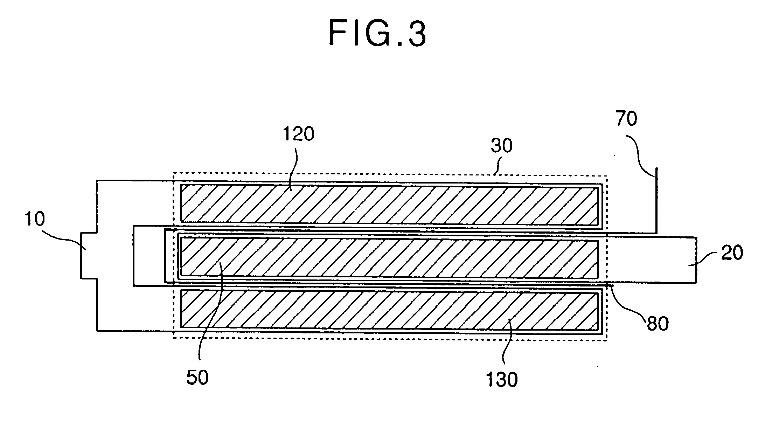

FIG. 3 is a diagram showing an equivalent circuit in the first and second preferred embodiments under the present invention.

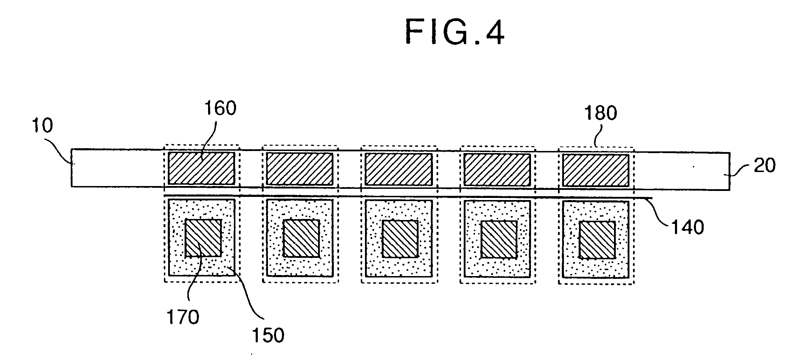

FIG. 4 is a top view showing a structure of a semiconductor device according to the third preferred embodiment under the present invention.

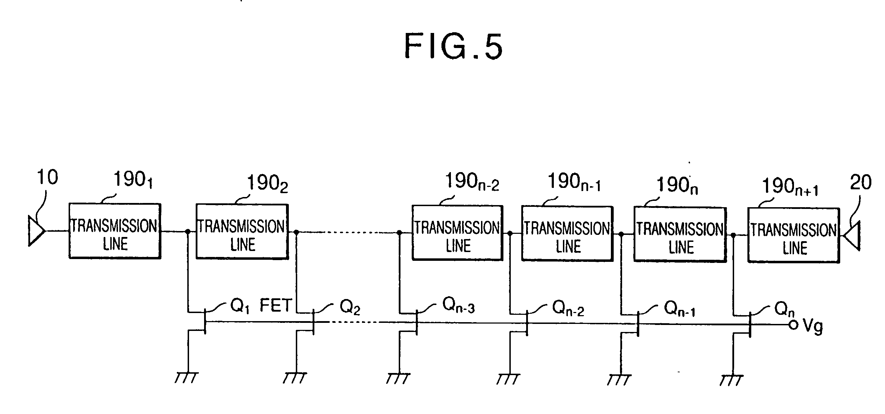

FIG. 5 is a top view showing a structure of a semiconductor device according to the fourth preferred embodiment under the present invention.

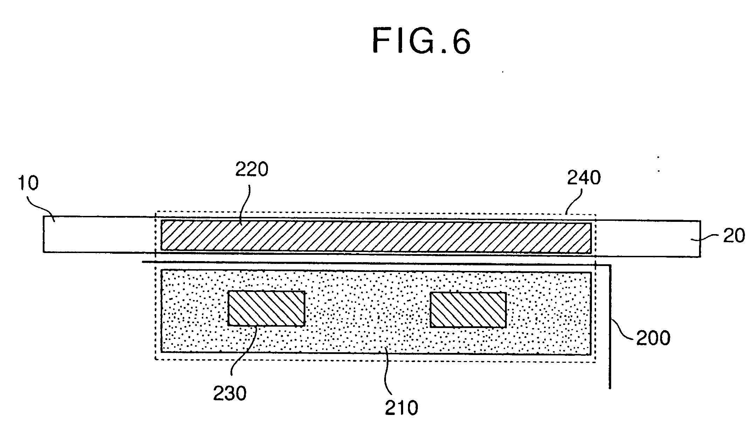

FIG. 6 is a diagram showing an equivalent circuit in the third and fourth preferred embodiments under the present invention.

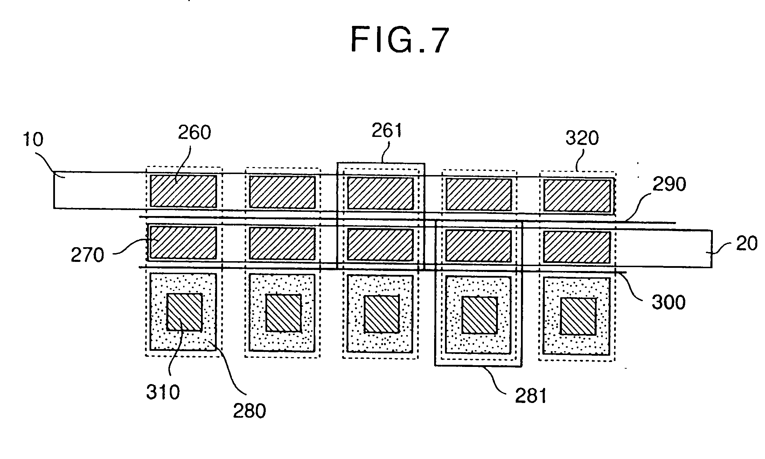

FIG. 7 is a top view showing a structure of a semiconductor device according to the fifth preferred embodiment under the present invention.

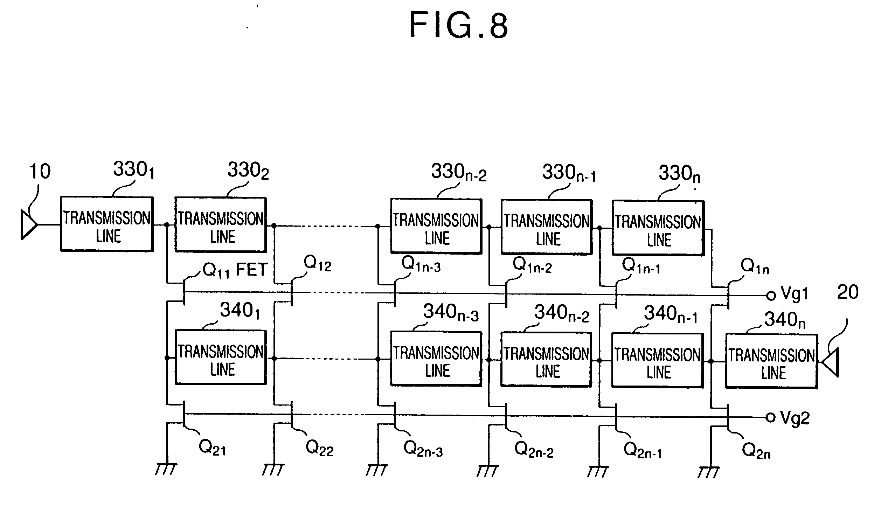

FIG. 8 is a top view showing a structure of a semiconductor device according to the sixth preferred embodiment under the present invention.

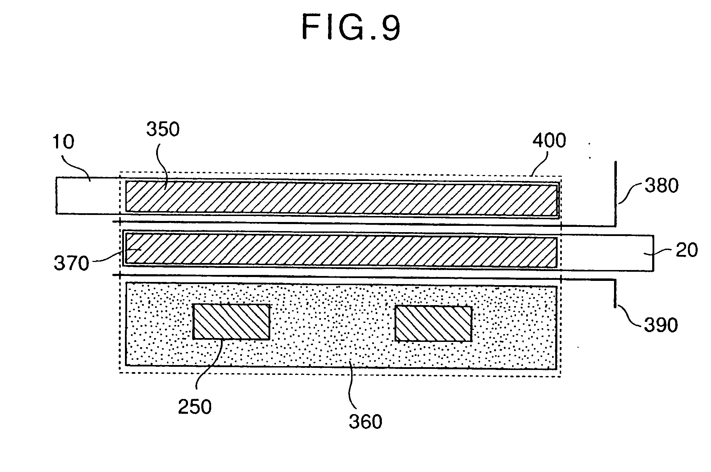

FIG. 9 is a diagram showing an equivalent circuit in the fifth and sixth preferred embodiments under the present invention.

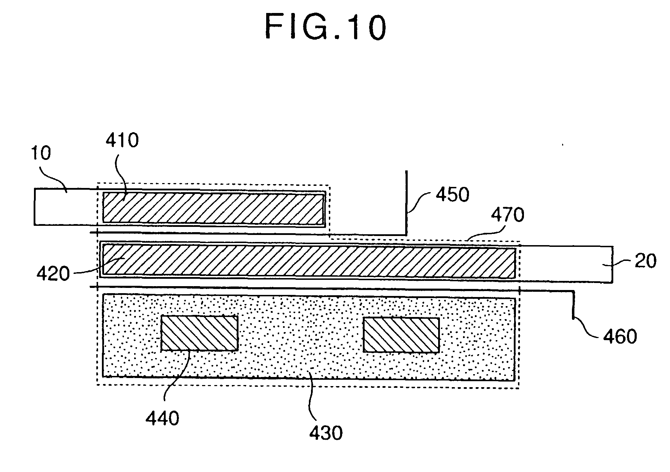

FIG. 10 is a top view showing a structure of a semiconductor device according to the seventh preferred embodiment under the present invention.

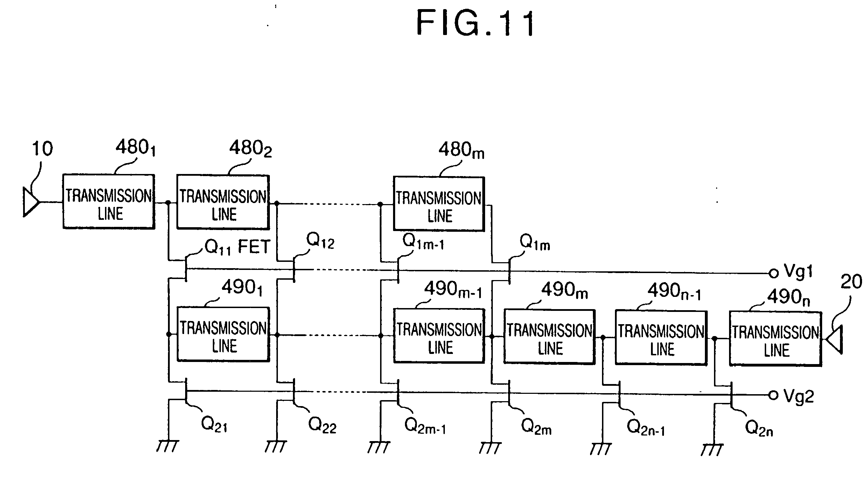

FIG. 11 is a diagram showing an equivalent circuit in the seventh preferred embodiment under the present invention.

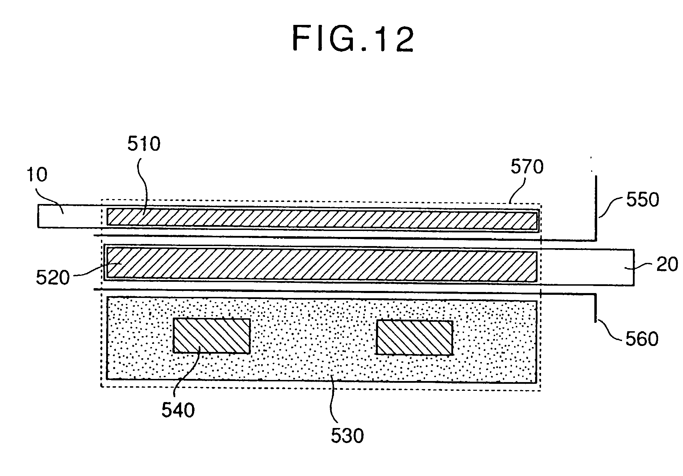

FIG. 12 is a top view showing a structure of a semiconductor device according to the eighth preferred embodiment under the present invention.

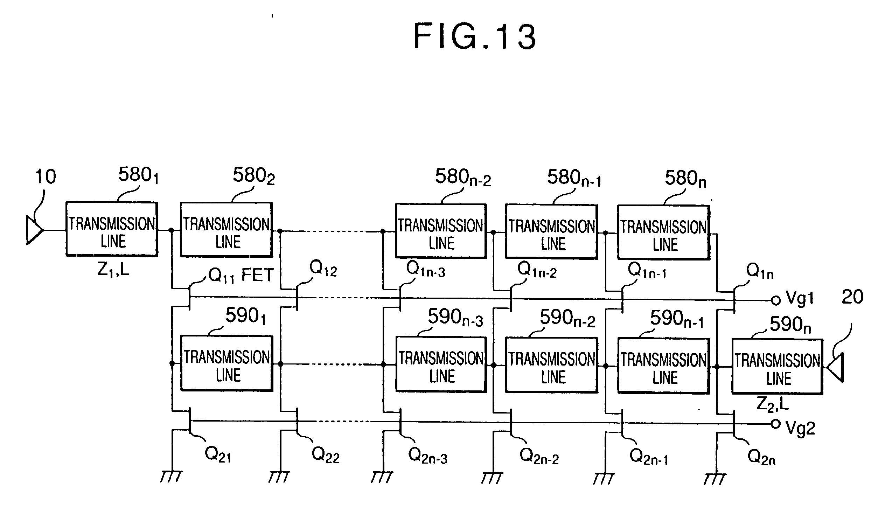

FIG. 13 is a diagram showing an equivalent circuit in the eighth preferred embodiment under the present invention.

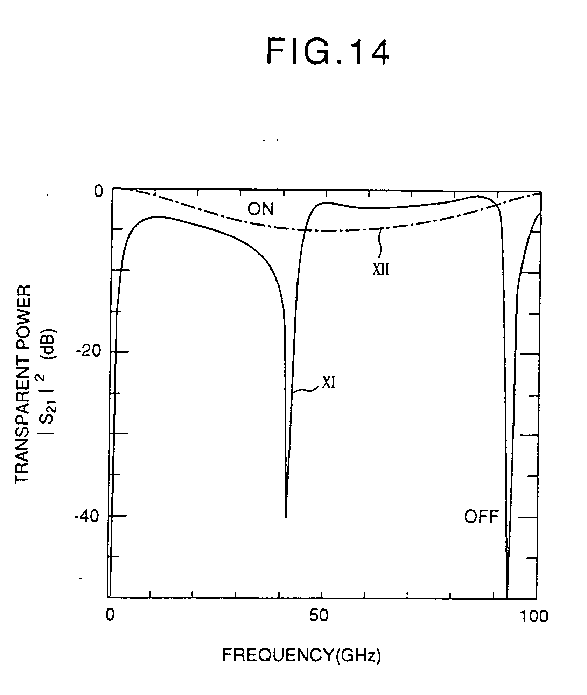

FIG. 14 is a diagram showing transparent characteristics of the first and second preferred embodiments under the present invention.

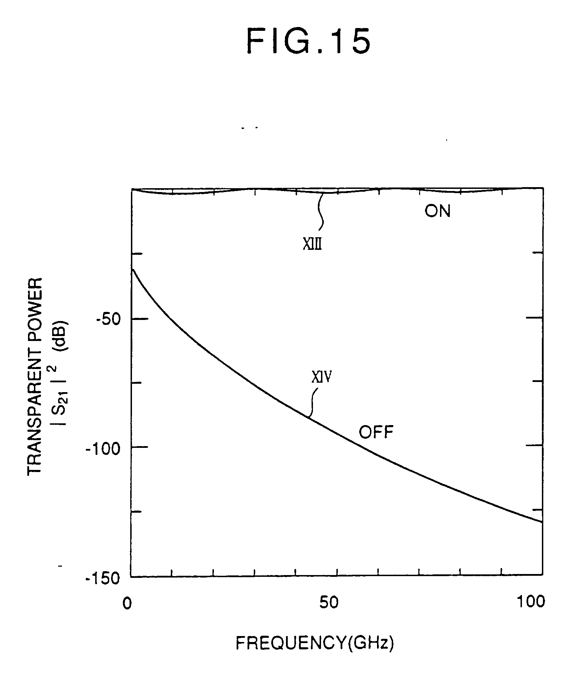

FIG. 15 is a diagram showing transparent characteristics of the third and fourth preferred embodiments under the present invention.

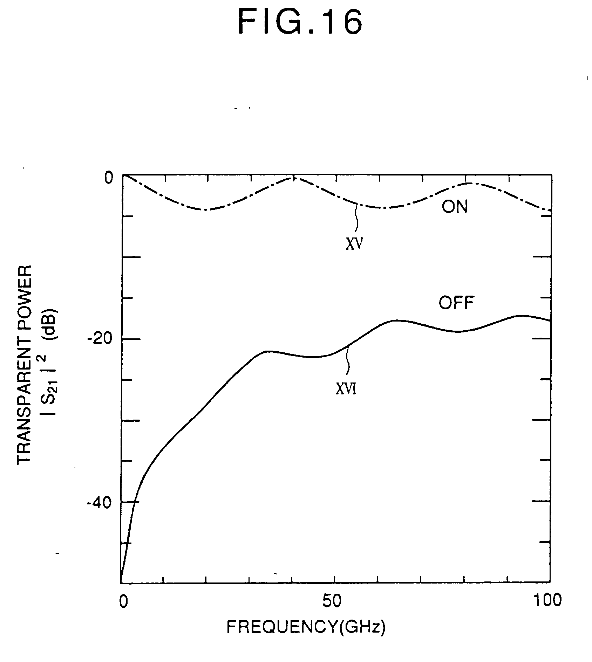

FIG. 16 is a diagram showing transparent characteristics of the fifth and sixth preferred embodiments under the present invention.

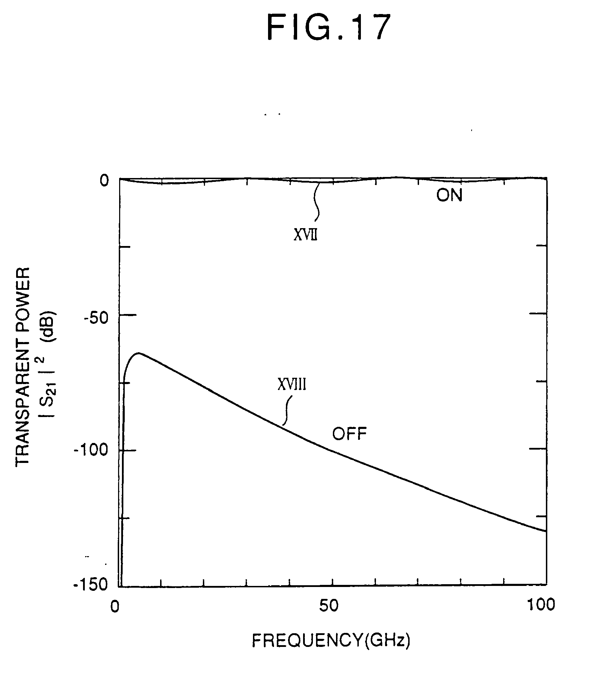

FIG. 17 is a diagram showing transparent characteristics of the seventh preferred embodiment under the present invention.

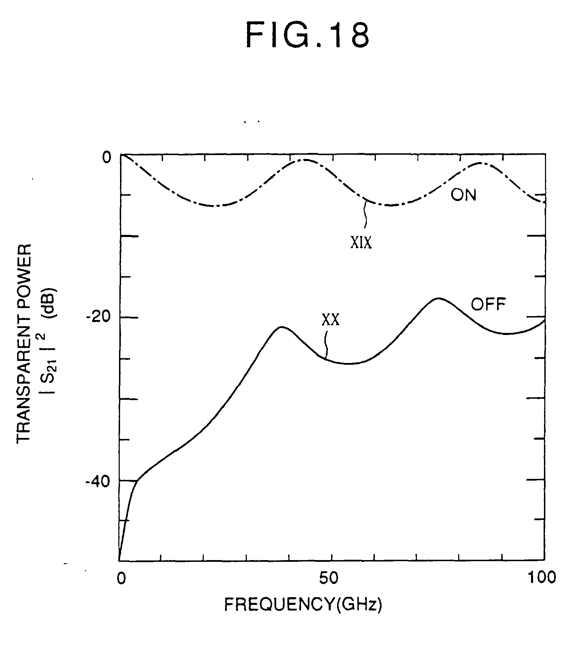

FIG. 18 is a diagram showing transparent characteristics of the eighth preferred embodiment under the present invention.

FIG. 19 is a circuit diagram showing a structure of a conventional serial structure switch.

FIG. 20 is a diagram showing transparent characteristics of a conventional serial structure switch.

FIG. 21 is a circuit diagram showing a structure of a conventional parallel structure switch.

FIG. 22 is a diagram showing transparent characteristics of a conventional parallel structure switch.

FIG. 23 is a circuit diagram showing a structure of a conventional serial-parallel structure switch.

FIG. 24 is a diagram showing transparent characteristics of a conventional serial-parallel structure switch.

FIG. 25 is a circuit diagram showing a structure of a switch comprising a conventional serial FET and a parallel connection coil.

FIG. 26 is a diagram showing transparent characteristics of a switch having the structure in FIG. 25.

FIG. 27 is a circuit diagram showing a structure of a switch comprising a conventional parallel FET and a serial λ/4 line.

FIG. 28 is a diagram showing transparent characteristics of a switch having the structure in FIG. 27.

FIG. 29 is a circuit diagram showing another example of a structure of a conventional serial-parallel structure switch.

FIG. 30 is a diagram showing transparent characteristics of a switch having the structure in FIG. 29.

## DESCRIPTION OF THE PREFERRED EMBODIMENT

The preferred embodiment of the present invention will be discussed hereinafter in detail with reference to the accompanying drawings. In the following description, numerous specific details are set forth in order to provide a thorough understanding of the present invention. It will be obvious, however, to those skilled in the art that the present invention may be practiced without these specific details. In other instance, well-known structures are not shown in detail in order to unnecessarily obscure the present invention.

FIG. 1 is a top view showing a structure of a semiconductor device according to the first preferred embodiment under the present invention.

As shown in FIG. 1, a semiconductor device of the first preferred embodiment under the present invention has a structure wherein two pieces of FET 41 and FET 61 having a gate electrode and a pair of ohmic electrodes pinching the above gate electrode and facing to each other is made into a incremental circuit, and a desired number of the above incremental circuits are arranged. A first FET 41 and a second FET 61 structuring a incremental circuit are surrounded by an active layer 30, and they use a second ohmic electrode as a shared electrode 50. Two pairs of FET 41 and FET 61 structuring a incremental circuit may be described as a concentrated constant.

Neighboring incremental circuits are arranged at certain intervals and so that gate electrodes should be in a straight line. And ohmic electrodes corresponding to neighboring incremental circuits are connected with lines that have an identical characteristic impedance. Namely, in FIG. 1, a gate electrode 70 of the first FET 41 and a gate electrode 80 of the second FET 61 are connected at the outside of an active layer 30 of plural connected incremental circuits. And the line that connects a first ohmic electrode 40 of the first FET 41 is connected with the line that connects a first ohmic electrode 60 of the second FET 41, and the center of the connected lines becomes a first input/output terminal 10. The end opposite to the first input/output terminal 10, of the line that connects the second ohmic electrode of the first FET 41 and a shared electrode 50 structuring the second ohmic electrode of the second FET 41 becomes a second input/output terminal 20.

In this embodiment, it is necessary that each of the length of gate electrode 70 of the first FET 41 and the length of the gate electrode 80 of the second FET 61 inside of the active layer 30, the length of the line including the ohmic electrode 40 in the first FET 41, the length of the line including the first ohmic electrode 60 of the second FET 61, and the length of the line including the shared electrode 50 should be at least over 1/16 of the propagation wavelength of used microwave or millimeter-wave. At this moment, the ohmic electrode functions as a distributed-constant line.

In general, when impedance of value $Z_0$ is connected to the input/output terminal, and transparent characteristics $|S_{21}|^2$ of transmission line whose characteristic impedance is Z and length is L is expressed by the following equation (1) if the propagation wavelength of used microwave or millimeter-wave is $\lambda$ :

$$|S_{21}|^2 = \frac{8Z^2 Z_0^2}{4Z^2 Z_0^2 + (Z^2 + Z_0^2)^2 - (Z^2 - Z_0^2)^2 \cos(4\pi L/\lambda)} \qquad (1)$$

From the above equation, in the case $Z = Z_0$, it occurs always that $|S_{21}|^2 = 1$ irrespective of the length of transmission line. On the other hand, in the case of $Z \neq Z_0$, when the length L of transmission line is equal to 1/4 of the propagation wavelength of microwave or millimeter-wave (L = $\lambda$/4), the value of cosine trigonometric function in the above equation becomes -1, the value of denominator in the above equation becomes maximum, and thus it is known that the transparent characteristics go down most and loss becomes large.

And when the length of transmission line is at least below 1/16 of the propagation wavelength of used microwave or millimeter-wave (L$\leq\lambda$/16), since the value of the cosine trigonometric function in the above equation is almost equal to 1, the decline of the transparent characteristics is almost negligible. In this case, the transmission line concerned may be handled with as a concentrated constant line whose length L may be ignored. On the other hand, when the length of transmission line is at least over 1/16 of the propagation wavelength of used microwave or millimeter-wave (L>$\lambda$/16), since the value of the cosine trigonometric function in the above equation deviates greatly from 1, the transmission line concerned may be evaluated to function as a distributed-constant line that depends on the length L.

FIG. 2 is a top view showing a structure of a semiconductor device according to the second preferred embodiment under the present invention. As shown in this FIG. 2, the equivalent circuit of this semiconductor device has a transmission line comprising a dielectric substrate and a metallic conductor, whose characteristic impedance is "Z" and length is "L", and an FET. And, it has a total of 2n pieces of incremental circuits, each of which comprises an FET, a first transmission line 100 whose one end is connected to the source of the above FET, and a second transmission line 110 whose one end is connected to the drain of the above FET. However, the number n of those incremental circuits share the second transmission line.

The source of FET Q of each incremental circuit is connected via the first transmission line 100 connected to the source of FET Q of neighboring other incremental circuit to the source of FET Q of the neighboring incremental circuit concerned. And the drain of FET Q of each incremental circuit is connected via the second transmission line 110 connected to the drain of FET Q of neighboring other incremental circuit to the source of FET Q of the neighboring incremental circuit concerned. And further, the gate of FET Q of each incremental circuit is connected in common so that it has the same potential Vg as the gate of FET Q of other incremental circuit.

And, among the first transmission line 100 structuring a circuit wherein at least 2 incremental circuits or more are connected, the line end not connected to FET Q is made as a first input/output terminal 10. and among the second transmission line 110 structuring the circuit concerned, the line end not connected to FET Q is made as a second input/output terminal 20. And the length of the first transmission line 100 structuring the circuit concerned is set to be longer than 1/16 of the propagation wavelength of used microwave or millimeter-wave, and the total length of the second transmission line 110 is set to be longer than 1/16 the propagation wavelength of used microwave or millimeter-wave.

The equivalent circuit of the semiconductor device shown in FIG. 2 comprises 2 units of the above circuits. The above 2 units of circuits share the second transmission line 110, and the first input/output terminal 10 of the 2 units are connected externally and share the first input/output terminal 10.

In the equivalent circuit structured as mentioned above, when FET Q of 2 units of incremental circuits to which a drain is connected in common is ON, electric power goes from the first input/output terminal 10 into the second input/output terminal 20, the switch circuit of the serial structure gets ON. On the contrary, when FET Q of 2 units of incremental circuits to which a drain is connected in common is OFF, electric power from the first input/output terminal 10 into the second input/output terminal 20 is shut off, and the switch circuit of the serial structure gets OFF. As known in comparison of FIG. 1 and FIG. 2, the line including the first ohmic electrode 40 of the first FET 41, the line including the first ohmic electrode 60 of the second FET 61, and the line including the shared electrode 50 have also the function as a distributed-constant line respectively.

FIG. 3 is a diagram showing an equivalent circuit in the first and second preferred embodiment under the present invention. By the way, in FIG. 3, identical codes are allotted to the same structure element as in the first preferred embodiment shown in FIG. 1.

As shown in this FIG. 3, the semiconductor device of the second preferred embodiment under the present invention has a gate electrode and 2 units of FET having a pair of ohmic electrodes pinching the gate electrode and facing to each other. Among the above 2 units of FET, the first ohmic electrode 120 of the first FET and the first ohmic electrode 130 of the second FET are connected by line outside of the active layer 30, and the center of the line is made as a first input/output terminal 10. While, the second ohmic electrode of the first FET and the second ohmic electrode of the second FET are set as a shared electrode 50. And the opposite end to the first input/output terminal 10 in the shared electrode 50 is set as a second input/output terminal 20.

And, a gate electrode 70 of the first FET is formed between the first ohmic electrode 120 of the first FET and the shared electrode 50, and a gate electrode 80 of the second FET is formed between the shared electrode 50 and the first ohmic electrode 130 of the second FET, and these 2 gate electrodes 70 and 80 are connected to each other outside of the active layer 30. That is, this preferred embodiment corresponds to the composition whose number of incremental elements in the first preferred embodiment is infinite.

In the second preferred embodiment under the present invention, the length of the gate electrode 70 of the first FET and the gate electrode 80 of the second FET in the active layer 30, the length of the first ohmic electrode 120 of the first FET in parallel with the gate electrodes 70 and 80, the length of the shared electrode 50 in the same direction, and the length of the first ohmic electrode 130 of the second FET in the same direction are set to be at least longer than 1/16 of the length of used microwave or millimeter-wave. Thereby, the equivalent circuit of the semiconductor device in the second preferred embodiment becomes same in practice as the transparent circuit of the semiconductor device in the first preferred embodiment shown in FIG. 1, as a consequence, the second preferred embodiment functions in the same manners as the first preferred embodiment.

FIG. 4 is a top view showing a structure of a semiconductor device according to the third preferred embodiment under the present invention.

As shown in this FIG. 4, a semiconductor device in the third preferred embodiment under the present invention has a structure wherein a gate electrode 140 and FET comprising a pair of ohmic electrodes 150 and 160 pinching the above gate electrode and facing to each other are covered with an active layer 180 and made into a incremental circuit, and a desired number of the above incremental circuits are arranged. The first ohmic electrode 160 is grounded by a via hole 170. The FET structuring incremental circuits may be described as a concentrated constant.

Neighboring incremental circuits are arranged at certain intervals and so that gate electrodes 140 should be in a straight line. And the second ohmic electrode between neighboring incremental circuits is connected by a line that has an identical characteristic impedance. One end of the line connected to the second ohmic electrode 160 is set as a first input/output terminal 10, while the other end is set as the second input/output terminal 20.

In this preferred embodiment, it is necessary that the length of the line including the second ohmic electrode 160 of FET should be longer than at least 1/16 of the propagation wavelength of used microwave or millimeter-wave.

FIG. 5 is a top view showing a structure of a semiconductor device according to the fourth preferred embodiment under the present invention. As shown in this FIG. 5, in the transparent circuit of this semiconductor device, the number n + 1 piece (wherein, n is an integer of 2 or more) of transmission lines 190 whose characteristic impedance is Z and length is "L" are connected in serial between the first input/output terminal 10 and the second input/output terminal 20, and a drain of FET Q whose source is grounded is connected to a common connection point between neighboring transmission lines 190. The number n of these gates of FET Q are connected in common, and are set so as to have the same gate electric potential Vg. Namely, the equivalent circuit shown in FIG. 5 structures a incremental circuit by a FET Q whose source is grounded and a transmission line 190 whose one end is connected to the drain of the above FET Q, and the number of the above incremental circuits are connected, and further a transmission line $190_{n+1}$ is connected.

In the equivalent circuit structured as shown above, when FET Q gets ON by the , electric power from the first input/output terminal 10 to the second input/output terminal 20 is shut off, and the switch circuit of the parallel structure becomes OFF. On the contrary, when FET Q gets OFF by the gate electric potential Vg, electric power goes from the first input/output terminal 10 to the second input/output terminal 20, and the switch circuit of the parallel structure becomes ON. As known from the comparison of FIG. 4 and FIG. 5, the line including the second ohmic electrode160 has also a function as a distributed-constant line. By the way, in FIG. 5, one unit of transmission line $190_{n+1}$ that does not structure a incremental circuit is not n essential structure requirement, therefore, it may not be arranged.

FIG. 6 is a diagram showing an equivalent circuit in the third and fourth preferred embodiments under the present invention.

As shown this FIG. 6, a semiconductor device in the fourth preferred embodiment under the present invention has a structure wherein a gate electrode 200 and FET comprising a pair of ohmic electrodes 210 and 220 pinching the above gate electrode and facing to each other are covered with an active layer 240 and made into a incremental circuit. The first ohmic electrode 210 is grounded by a via hole 230. One end of the second ohmic electrode 220 in parallel with the gate electrode 20 is set as a first input/output terminal 10, and the other end is set as a second input/output terminal 20, and signals of microwave or millimeter-wave are input and output. That is, this preferred embodiment corresponds to the composition whose number of incremental elements in the third preferred embodiment is infinite.

In the fourth, the length of the gate electrode 20 inside of the active layer 24, the length of the first ohmic electrode 21 and the second ohmic electrode 22 are set to be over at least 1/16 of the propagation wavelength of used microwave or millimeter-wave. Thereby, the equivalent circuit of the semiconductor device in the fourth preferred embodiment becomes same in practice as the transparent circuit of the semiconductor device in the third preferred embodiment shown in FIG. 5, as a consequence, the second preferred embodiment functions in the same manners as the third preferred embodiment.

FIG. 7 is a top view showing a structure of a semiconductor device according to the fifth preferred embodiment under the present invention.

As shown in FIG. 7, a semiconductor device of the fifth preferred embodiment under the present invention has a structure wherein two pieces of FET 261 and FET 281 having a gate electrode and a pair of ohmic electrodes pinching the above gate electrode and facing to each other is made into a incremental circuit, and a desired number of the above incremental circuits are arranged. A first FET 261 and a second FET 281 structuring a incremental circuit are surrounded by an active layer 320, and they use a second ohmic electrode as a shared electrode 270. And the first ohmic electrode of the second FET 281 is grounded by a via hole 310. Two pairs of FET 261 and FET 281 structuring a incremental circuit may be described as a concentrated constant.

Neighboring incremental circuits are arranged at certain intervals and so that gate electrodes should be in a straight line. And ohmic electrodes corresponding to neighboring incremental circuits are connected with lines that-have an identical characteristic impedance. Namely, in FIG. 7, the first ohmic electrode 260 of the first FET 261 is connected by a line, and one end of the line is made as a first input/output terminal 10. And a shared electrode 270 is connected by a separate line, and the end of the line in the opposite direction to the first input/output terminal 10 is made as a second input/output terminal 20.

In the present preferred embodiment, the length including the first ohmic electrode 260 of the first FET 261, and the length of the shared electrode 270 are set to over at least 1/16 of the propagation wavelength of used microwave or millimeter-wave.

FIG. 8 is a top view showing a structure of a semiconductor device according to the sixth preferred embodiment under the present invention. As shown in this FIG. 8, in the equivalent circuit of this semiconductor device, the number n of transmission lines 330 whose characteristic impedance is Z and length is L are connected in serial to an input/output terminal 10, and the number n of transmission lines 340 whose characteristic impedance is Z and length is L are connected in serial to an input/output terminal 20. And among the transmission lines 330, to the common connection points between neighboring transmission lines 330, connected are corresponding number of drains (or sources) of FETs among the number n of FET Q. In the same manner, among the transmission lines 340, to the common connection points between neighboring transmission lines 340, connected are corresponding number of sources (or drains) of FETs among the number n of FET Q, and further corresponding number of drains of FET Q among the number n of FET Q whose sources are grounded are connected.

And, each of the number n of gates of FET $Q_{11}$ through $Q_{1n}$ arranged between the common connection points between the transmission lines 330 and the common connection points between the transmission lines 340 is connected by the gate electrode 290 of the first FET 261, and is made into the same gate electric potential Vg1. In the same manner, each of the number n of gates of FET $Q_{21}$ through $Q_{2n}$ that are connected to common connection points between the transmission lines 340 and grounded is connected by the gate electrode 300 of the second FET 281, and made into the same gate electric potential Vg2. And the total length of the transmission line 330 is set to be longer than 1/16 of propagation wavelength of signals that are input and output to and from the first input/output terminal 10. In the same manner, the total length of the transmission lines 340 is set to be longer than 1/16 of propagation wavelength of signals that are input and output to and from the second input/output terminal 20.

Namely, the equivalent circuit of the semiconductor device shown in FIG. 8 has a structure having plural units of FET $Q_{1k}$ (wherein k is an optional value from-1 to n), and transmission line $330_k$ whose one end is connected to the source of the FET $Q_{1k}$ concerned, transmission line $340_k$ whose one end is connected to the drain of FET $Q_{1k}$, and FET $Q_{2k}$ whose source is grounded and whose drain is connected to the drain of FET $Q_{1k}$ and one end of the transmission line $340_k$.

In the equivalent circuit structured as shown above, when FET $Q_{11}$ through $Q_{1n}$ are turned ON by the gate electric potential Vg1 and FET $Q_{21}$ through $Q_{2n}$ are turned OFF by the gate electric potential Vg2, electric power goes from the first input/output terminal 10 via transmission lines 330 and 340 to the second input/output terminal 20, and thereby the switch circuit gets ON. On the contrary, when FET $Q_{11}$ through $Q_{1n}$ are turned OFF by the gate electric potential Vg1, and FET $Q_{21}$ through $Q_{2n}$ are turned ON by the gate electric potential Vg2, electric power from the first input/output terminal 10 to the second input/output terminal 20 is shut off, as a result, the switch circuit gets OFF. And as known in the comparison of FIG. 7 and FIG. 8, the first ohmic electrode 260 and shared electrode 270 of FET $Q_{11}$ through $Q_{1n}$ have also a function as a distributed-constant line.

FIG. 9 is a diagram showing an equivalent circuit in the fifth and sixth preferred embodiments under the present invention.

As shown in this FIG. 9, the semiconductor device of the sixth preferred embodiment under the present invention has a gate electrode and 2 units of FET having a pair of ohmic electrodes pinching the gate electrode and facing to each other and covered with an active layer 400. Among the above 2 units of FET, the one end in longer direction of the first ohmic electrode 350 of the first FET is set as a first input/output terminal 10 that outputs and inputs signals of microwave or millimeter-wave. And the first ohmic electrode 360 of the second FET is grounded via a via hole 250. And further, the second ohmic electrode of the first FET and the second ohmic electrode of the second FET are set as a shared electrode 370. And the opposite end to the first input/output terminal 10 in the shared electrode 370 is set as a second input/output terminal 20 that outputs and inputs signals of microwave or millimeter-wave.

And a gate electrode 380 is formed between the first ohmic electrode 350 of the first FET and the shared electrode 370, and a gate electrode 390 is formed between the shared electrode 370 and the first ohmic electrode 360 of the second FET. That is, this preferred embodiment corresponds to the composition whose number of incremental elements in the fifth preferred embodiment is infinite.

In the sixth preferred embodiment, the length of gate electrode 380 of the first FET and the length of the gate electrode 390 of the second FET inside of the active layer 400, the length of the ohmic electrode 350 in the first FET, the length of the shared electrode 370, and the length of the first ohmic electrode 360 of the second FET are set to be over at least 1/16 of the propagation wavelength of used microwave or millimeter-wave. Thereby, the equivalent circuit diagram of the semiconductor device of the sixth preferred embodiment shown in FIG. 6 becomes substantially same as the equivalent circuit diagram of the semiconductor device of the fifth preferred embodiment shown in FIG. 7, and acts as same as the fifth preferred embodiment.

FIG. 10 is a top view showing a structure of a semiconductor device according to the seventh preferred embodiment under the present invention.

As shown in this FIG. 10, the semiconductor device of the seventh preferred embodiment under the present invention has a gate electrode and 2 units of FET having a pair of ohmic electrodes pinching the gate electrode and facing to each other and covered with an active layer 470. Among the above 2 units of FET, the one end in longer direction of the first ohmic electrode 410 of the first FET is set as a first input/output terminal 10 that outputs and inputs signals of microwave or millimeter-wave. And the first ohmic electrode 430 of the second FET is grounded via a via hole 440. And further, the second ohmic electrode of the first FET and the second ohmic electrode of the second FET are set as a shared electrode 420. And the opposite end to the first input/output terminal 10 in the shared electrode 420 is set as a second input/output terminal 20 that outputs and inputs signals of microwave or millimeter-wave. In the seventh preferred embodiment, as shown in the figure, the length of the gate electrode 450 of the first FET differs from that of the gate electrode 460 of the second FET.

And a gate electrode 450 is formed between the first ohmic electrode 410 of the first FET and the shared electrode 420, and further a gate electrode 460 is formed between the shared electrode 420 and the first ohmic electrode 430 of the second FET.

In the seventh preferred embodiment, as mentioned above, the length of the gate electrode 450 of the first FET inside of the active layer 470 differs from that of the gate electrode 460 of the second FET. And the length of the gate electrode 460 of the second FET inside of the active layer 470, the length of the shared electrode 420, and the length of the first ohmic electrode 430 of the second FET are set to be longer than at least 1/16 of the propagation wavelength of used microwave or millimeter-wave. However, the length of the gate electrode 450 of the first FET inside of the active layer 470 and the length of the first ohmic electrode 410 of the first FET may be not limited to 1/16 of the propagation wavelength of used microwave or millimeter-wave. And to the contrary to this preferred embodiment, the gate width of the first FET may be wider than the gate width of the second FET, and accordingly the length of the first ohmic electrode of the first FET may be longer than the length of the first ohmic electrode of the second FET.

FIG. 11 is a diagram showing an equivalent circuit in the seventh preferred embodiment under the present invention. As shown in this FIG. 11, in the equivalent circuit of this semiconductor device, the number m of transmission lines 480 whose characteristic impedance is Z and length is L are connected in serial to the first input/output terminal 10, and the number n (provided, n>m in the present preferred embodiment) of transmission lines 490 whose characteristic impedance is Z and length is L are connected in serial to the second input/output terminal 20. And among the transmission lines 480, to the common connection points between neighboring transmission lines 480, connected are corresponding number of drains (or sources) of FETs among the number n of FET Q. In the same manner, among the transmission lines 490, to the common connection points between neighboring transmission lines 490, connected are corresponding number of sources (or drains) of FETs among the number m of FET Q, and further corresponding number of drains of FET Q among the number n of FET Q whose sources are grounded are connected.

And, each of the number m of gates of FET arranged between the common connection points between the transmission lines 480 and the common connection points between the transmission lines 490 is connected by the gate electrode 450 of the first FET, and is made into the same gate electric potential Vg1. In the same manner, each of the number n of gates of FET Q that are connected to common connection points between the transmission lines 490 and grounded is connected by the gate electrode 460 of the second FET, and made into the same gate electric potential Vg2. And the total length of the transmission line 490 is set to be longer than 1/16 of propagation wavelength of signals that are input and output to and from the first input/output terminal 10. In the same manner, the total length of the transmission lines 340 is set to be longer than 1/16 of propagation wavelength of used microwave or millimeter-wave.

In the equivalent circuit structured as shown above, when FET $Q_{11}$ through $Q_{1m}$ are turned ON by the gate electric potential Vg1, and FET $Q_{21}$ through $Q_{2n}$ are turned OFF by the gate electric potential Vg2, electric power goes from the first input/output terminal 10 to the second input/output terminal 20, and thereby the switch circuit gets ON. On the contrary, when FET $Q_{11}$ through $Q_{1m}$ are turned OFF by the gate electric potential Vg1, and FET $Q_{21}$ through $Q_{2n}$ are turned ON by the gate electric potential Vg2, electric power from the first input/output terminal 10 to the second input/output terminal 20 is shut off, as a consequence, the switch circuit gets OFF. And as known in the comparison of FIG. 10 and FIG. 11, the shared electrode 420 has also a function as a distributed-constant line.

FIG. 12 is a top view showing a structure of a semiconductor device according to the eighth preferred embodiment under the present invention.

As shown in this FIG. 12, the semiconductor device of the eighth preferred embodiment under the present invention has a gate electrode and 2 units of FET having a pair of ohmic electrodes pinching the gate electrode and facing to each other and covered with an active layer 570. Among the above 2 units of FET, the one end in longer direction of the first ohmic electrode 510 of the first FET is set as a first input/output terminal 10 that outputs and inputs signals of microwave or millimeter-wave. And the first ohmic electrode 530 of the second FET is grounded via a via hole 540. And further, the second ohmic electrode of the first FET and the second ohmic electrode of the second FET are set as a shared electrode 520. And the opposite end to the first input/output terminal 10 in the shared electrode 520 is set as a second input/output terminal 20 that outputs and inputs signals of microwave or millimeter-wave. In the seventh preferred embodiment, as shown in the figure, the length of the gate electrode 450 of the first FET differs from that of the gate electrode 460 of the second FET.

As shown in this FIG. 12, the semiconductor device of the eighth preferred embodiment under the present invention has a gate electrode and 2 units of FET having a pair of ohmic electrodes pinching the gate electrode and facing to each other and covered with an active layer 570. Among the above 2 units of FET, the one end in longer direction of the first ohmic electrode 510 of the first FET is set as a first input/output terminal 10 that outputs and inputs signals of microwave or millimeter-wave. And the first ohmic electrode 530 of the second FET is grounded via a via hole 540. And further, the second ohmic electrode of the first FET and the second ohmic electrode of the second FET are set as a shared electrode 520. And the opposite end to the first input/output terminal 10 in the shared electrode 520 is set as a second input/output terminal 20 that outputs and inputs signals of microwave or millimeter-wave. In the eighth preferred embodiment, as shown in the figure, the width of the gate electrode 450 of the first FET differs from that of the gate electrode 460 of the second FET.

And a gate electrode 550 is formed between the first ohmic electrode 510 of the first FET and the shared electrode 520, and further a gate electrode 560 is formed between the shared electrode 520 and the first ohmic electrode 530 of the second FET.

In the eighth preferred embodiment, as mentioned above, the width of the first ohmic electrode 510 of the first FET differs from that of the shared electrode 520. And the length of the gate electrode 560 of the first FET and the gate electrode 560 of the second FET inside of the active layer 57, the length of the shared electrode 520, and the length of the first ohmic electrode 530 of the second FET are set to be longer than at least 1/16 of the propagation wavelength of used microwave or millimeter-wave.

FIG. 13 is a diagram showing an equivalent circuit in the eighth preferred embodiment under the present invention. As shown in this FIG. 13, in the equivalent circuit of this semiconductor device, the number n of transmission lines 580 whose characteristic impedance is Z1 and length is L are connected in serial to the first input/output terminal 10, and the number n of transmission lines 590 whose characteristic impedance is Z2 ($\neq$Z1) and length is L are connected in serial to the second input/output terminal 20. And among the transmission lines 580, to the common connection points between neighboring transmission lines 580, connected are corresponding number of drains (or sources) of FETs among the number n of FET Q. In the same manner, among the transmission lines 590, to the common connection points between neighboring transmission lines 590, connected are corresponding number of sources (or drains) of FETs among the number n of FET Q, and further corresponding number of drains of FET Q among the number n of FET Q whose sources are grounded are connected.

And, each of the number n of gates of FET arranged between the common connection points between the transmission lines 580 and the common connection points between the transmission lines 590 is connected by the gate electrode 550 of the first FET, and is made into the same gate electric potential Vg1. In the same manner, each of the number n of gates of FET Q that are connected to common connection points between the transmission lines 590 and grounded is connected by the gate electrode 560 of the second FET, and made into the same gate electric potential Vg2.

In the equivalent circuit structured as shown above, when FET $Q_{11}$ through $Q_{1n}$ are turned ON by the gate electric potential Vg1, and FET $Q_{21}$ through $Q_{2n}$ are turned OFF by the gate electric potential Vg2, electric power goes from the first input/output terminal 10 via the transmission lines 580 and 590 to the second input/output terminal 20, and thereby the serial-parallel switch circuit gets ON. On the contrary, when FET $Q_{11}$ through $Q_{1n}$ are turned OFF by the gate electric potential Vg1, and FET $Q_{21}$ through $Q_{2n}$ are turned ON by the gate electric potential Vg2, electric power from the first input/output terminal 10 to the second input/output terminal 20 is shut off, as a consequence, the serial-parallel switch circuit gets OFF. And as known in the comparison of FIG. 12 and FIG. 13, the ohmic electrode 510 of FET $Q_{11}$ through $Q_{1n}$ and the shared electrode 420 have also a function as a distributed-constant line.

In the next place, the transparent characteristics in the actual action of each of the above preferred embodiments are explained hereinafter.

In the first preferred embodiment shown in FIG. 1, a GaAlAs system hetero connection FET was used as a semiconductor substrate, and 10 pieces of FET whose gate length was 0.15 $\mu$m and the length of its gate electrode inside of the active layer 30 was 100 $\mu$m was used. The width of ohmic electrodes 40 and 60 was 38.2 $\mu$m, and 50$\Omega$ impedances were connected to the first input/output terminal 10 and the second input/output terminal 20. And in order to make the gate bias circuit into a high impedance, 2 k$\Omega$ resistance element using epitaxial layer was inserted into the line between the gate electrode and the gate bias. The interval between incremental circuits was 1 $\mu$m.

FIG. 14 shows the transparent characteristics in the ON status and the OFF status of the semiconductor device of the first preferred embodiment under the present invention. In this FIG. 14, the vertical axis shows the transparent power $|S_{21}|^2$ between the first input/output terminal 10 and the second input/output terminal 20, while the horizontal axis shows the frequency of input signals. The above is true to the respective transparent characteristics diagrams shown in FIG. 15 throughout FIG. 18.

In a conventional device shown in FIG. 20, isolation as the power breaking capacity at turning OFF the switch decreased greatly as the frequency increased, on the contrary, in the first preferred embodiment according to the present invention, as shown by the solid line XI in FIG. 14, sharp and large isolation was attained at desired frequency. And with respect to insertion loss as the power loss amount at turning the switch OFF, as shown by the dashed line XII, a few characteristics was obtained in wide frequency. Therefore, according to this preferred embodiment, it was possible to attain large power transmission, low insertion loss, and high isolation at the same time, which has so far never been realized.

For information, with respect to the characteristics at 94 GHz, the conventional device attained insertion loss -0.014dB and isolation 0.069dB, on the other hand, the first preferred embodiment attained insertion loss -1.83dB and isolation -58.5dB, thus characteristics have been improved to a great extent.

Then, explanation is made on the second preferred embodiment shown in FIG. 3.

In the second preferred embodiment shown in FIG. 3, a GaAlAs system hetero connection FET was used as a semiconductor substrate, and 10 pieces of FET whose gate length was 0.15 $\mu$m and the length of its gate electrode inside of the active layer 30 was 500 $\mu$m was used. The width of ohmic electrodes 120 and 130 was 38.2 $\mu$m, and 50$\Omega$ impedances were connected to the first input/output terminal 10 and the second input/output terminal 20. And in order to make the gate bias circuit into a high impedance, 2k$\Omega$ resistance element using epitaxial layer was inserted into the line between the gate electrode and the gate bias.

The transparent characteristics in the ON status and the OFF status of the semiconductor device of the second preferred embodiment under the present invention appeared same as the transparent characteristics shown in FIG. 14, and the second preferred embodiment attained insertion loss -1.83dB and isolation -58.5dB at 94 GHz, thus characteristics have been improved to a great extent.

Next, explanation is made on the third preferred embodiment shown in FIG. 4.

In the third preferred embodiment shown in FIG. 4, a GaAlAs system hetero connection FET was used as a semiconductor substrate, and 10 pieces of FET whose gate length was 0.15 $\mu$m and the length of the gate electrode 140 inside of the active layer 180 was 100 $\mu$m was used. The width of ohmic electrodes 160 was 20 $\mu$m, and 50$\Omega$ impedances were connected to the first input/output terminal 10 and the second input/output terminal 20. And in order to make the gate bias circuit into a high impedance, 2 k$\Omega$ resistance element using epitaxial layer was inserted into the line between the gate electrode and the gate bias. The interval between incremental circuits was 1 $\mu$m.

FIG. 15 shows the transparent characteristics in the ON status and the OFF status of the semiconductor device of the third preferred embodiment under the present invention.

In a conventional device shown in FIG. 22, isolation loss increased greatly as the frequency increased, on the contrary, in the third preferred embodiment according to the present invention, as shown by the dashed line XIII in FIG. 15, isolation loss did not increase though there were seen vibration around 0 dB in accompany with changes in frequency. This comes from the same reason for that a cosine trigonometric function is included in the equation (1) to obtain the abovementioned transparent characteristics $|S_{21}|^2$

In a conventional device shown in FIG. 22, isolation was constant irrespective of frequency, on the other hand, in the third preferred embodiment according to the present invention, as shown by the solid line XIV in FIG. 15, isolation increased as frequency became high. Therefore, according to the third preferred embodiment, it was possible to attain large power transmission, low insertion loss, and high isolation at the same time, which has so far never been realized.

For information, with respect to the characteristics at 60 GHz, the conventional device attained insertion loss -9.54dB and isolation -30.17dB, on the other hand, the third preferred embodiment attained insertion loss -0.098dB and isolation -103.1dB, thus characteristics have been improved to a great extent.

Then, explanation is made on the fourth preferred embodiment shown in FIG. 6.

In the fourth preferred embodiment shown in FIG. 6, a GaAlAs system hetero connection FET was used as a semiconductor substrate, whose gate length was 0.15 $\mu$m and the length of its gate electrode inside of the active layer 240 was 1 mm was used. The width of ohmic electrodes 220 was 20 $\mu$m, and 50 $\Omega$ impedances were connected to the first input/output terminal 10 and the second input/output terminal 20. And in order to make the gate bias circuit into a high impedance, 2 k$\Omega$ resistance element using epitaxial layer was inserted into the line between the gate electrode and the gate bias.

The transparent characteristics in the ON status and the OFF status of the semiconductor device of the fourth preferred embodiment under the present invention appeared same as the transparent characteristics shown in FIG. 15, and the fourth preferred embodiment attained insertion loss -0.098dB and isolation -103.1dB at 60 GHz, thus characteristics have been improved to a great extent.

Next, explanation is made on the fifth preferred embodiment shown in FIG. 7.

In the fifth preferred embodiment shown in FIG. 7, a GaAlAs system hetero connection FET was used as a semiconductor substrate, and 20 pieces in total of FET whose gate length was 0.15$\mu$m and the length of the gate electrode inside of the active layer 320 was 100 $\mu$m was used in serial and parallel. The width of ohmic electrodes in both the first ohmic electrode 260 of the first FET and the shared electrode 270 was 20 $\mu$m, and 50 $\Omega$ impedances were connected to the first input/output terminal 10 and the second input/output terminal 20. And in order to make the gate bias circuit into a high impedance, 2 k$\Omega$ resistance element using epitaxial layer was inserted into the line between the gate electrode and the gate bias in each FET. The interval between incremental circuits was 1 $\mu$m.

FIG. 16 shows the transparent characteristics in the ON status and the OFF status of the semiconductor device of the fifth preferred embodiment under the present invention.

In a conventional device shown in FIG. 24, isolation loss increased greatly as the frequency increased, on the contrary, in the fifth preferred embodiment according to the present invention, as shown by the dashed line XV in FIG. 16, isolation loss vibrated greatly and increased around 0 dB in accompany with changes in frequency. This comes from the same reason for that a cosine trigonometric function is included in the equation (1) to obtain the abovementioned transparent characteristics $|S_{21}|^2$.

In a conventional device shown in FIG. 24, isolation was almost constant at frequency over 10 GHz, on the other hand, in the fifth preferred embodiment according to the present invention, as shown by the solid line XVI in FIG. 16, isolation vibrated and decreased as frequency became high. This vibration comes from the same reason for that a cosine trigonometric function is included in the equation (1) to obtain the abovementioned transparent characteristics $|S_{21}|^2$.

Therefore, according to the fifth preferred embodiment, it was possible to attain large power transmission, low insertion loss, and high isolation at the same time, which has so far never been realized.

For information, with respect to the characteristics at 42 GHz, the conventional device attained insertion loss -7.1dB and isolation -30.4dB, on the other hand, the third preferred embodiment attained insertion loss -0.48dB and isolation -22.1dB, thus characteristics have been improved to a great extent. By the way, it is possible to attain desired frequency characteristics by changing the gate width (the length of the gate electrode in active layer) and the length of the ohmic electrode appropriately.

Next, explanation is made on the sixth preferred embodiment shown in FIG. 9.

In the sixth preferred embodiment shown in FIG. 9, a GaAlAs system hetero connection FET was used as a semiconductor substrate, and FET whose gate length was 0.15 $\mu$m and the length of the gate electrode inside of the active layer 400 was 1 mm was used in both serial and parallel. The width of ohmic electrodes in both the first ohmic electrode 350 of the first FET and the shared electrode 370 was 20 $\mu$m, and 50 $\Omega$ impedances were connected to the first input/output terminal 10 and the second input/output terminal 20. And in order to make the gate bias circuit into a high impedance, 2k$\Omega$ resistance element using epitaxial layer was inserted into the line between the gate electrode and the gate bias in each FET.

The transparent characteristics in the ON status and the OFF status of the semiconductor device of the sixth preferred embodiment under the present invention appeared same as the transparent characteristics shown in FIG. 16, and the sixth preferred embodiment attained insertion loss -0.48dB and isolation -22.1dB at 42 GHz, thus insertion loss has been improved to a great extent.

Then, explanation is made on the seventh preferred embodiment shown in FIG. 10.

In the seventh preferred embodiment shown in FIG. 10, a GaAlAs system hetero connection FET was used as a semiconductor substrate, and FET whose gate length was 0.15 $\mu$m and the length of its gate electrode inside of the active layer 470 was used in serial, while FET wherein the length of its gate electrode inside of the active layer 470 was 1 mm was used in parallel. The width of ohmic electrodes 410 of the first FET and the shared electrode was 20 $\mu$m, and 50 $\Omega$ impedances were connected to the first input/output terminal 10 and the second input/output terminal 20. And in order to make the gate bias circuit into a high impedance, 2k$\Omega$ resistance element using epitaxial layer was inserted into the line between the gate electrode and the gate bias in each FET.

FIG. 17 shows the transparent characteristics in the ON status and the OFF status of the semiconductor device of the seventh preferred embodiment under the present invention.

In a conventional device shown in FIG. 30, isolation loss increased greatly as the frequency increased, on the contrary, in the seventh preferred embodiment according to the present invention, as shown by the dashed line XVII in FIG. 17, though isolation loss vibrated greatly around 0 dB in accompany with changes in frequency, there was not monotonous increase. This comes from the same reason for that a cosine trigonometric function is included in the equation (1) to obtain the abovementioned transparent characteristics

$$|S_{21}|^2.$$

And in a conventional device shown in FIG. 30, isolation decreased as the frequency increased, on the contrary, in the seventh preferred embodiment according to the present invention, as shown by the solid line XVIII in FIG. 16, isolation increased monotonously as frequency became high. Therefore, according to the seventh preferred embodiment, it was possible to attain large power transmission, low insertion loss, and high isolation at the same time, which has so far never been realized.

For information, with respect to the characteristics at 100 GHz, the conventional device attained insertion loss -14.8dB and isolation -33.4dB, on the other hand, the seventh preferred embodiment attained insertion loss -0.9dB and isolation -132.1dB, thus characteristics both in insertion loss and isolation have been improved to a great extent.

Next, explanation is made on the eighth preferred embodiment shown in FIG. 12.

In the eighth preferred embodiment shown in FIG. 12, a GaAlAs system hetero connection FET was used as a semiconductor substrate, and FET whose gate length was 0.15 $\mu$m and the length of the gate electrode inside of the active layer 570 was 1 mm was used in both serial and parallel. The width of ohmic electrodes in the first ohmic electrode 510 of the first FET was 100 $\mu$m and the width of the shared electrode 520 was 10 $\mu$m, and 50$\Omega$ impedances were connected to the first input/output terminal 10 and the second input/output terminal 20. And in order to make the gate bias circuit into a high impedance, 2 k$\Omega$ resistance element using epitaxial layer was inserted into the line between the gate electrode and the gate bias in each FET.

FIG. 18 shows the transparent characteristics in the ON status and the OFF status of the semiconductor device of the eighth preferred embodiment under the present invention.

In a conventional device shown in FIG. 24, isolation loss increased greatly as the frequency increased, on the contrary, in the eighth preferred embodiment according to the present invention, as shown by the dashed line XIX in FIG. 18, though isolation loss vibrated around 0 dB in accompany with changes in frequency, there was not monotonous increase. This comes from the same reason for that a cosine trigonometric function is included in the equation (1) to obtain the abovementioned transparent characteristics $|S_{21}|^2$.

And in a conventional device shown in FIG. 24, isolation decreased as the frequency increased, on the contrary, in the eighth preferred embodiment according to the present invention, as shown by the solid line XX in FIG. 18, isolation characteristics though isolation loss vibrated around 0 dB in accompany with changes in vibrated and increased as frequency became high. Therefore, according to the eighth preferred embodiment, it was possible to attain large power transmission, low insertion loss, and high isolation at the same time, which has so far never been realized.

For information, with respect to the characteristics at 85 GHz, the conventional device attained insertion loss -12.4dB and isolation -30.2dB, on the other hand, the eighth preferred embodiment attained insertion loss -1.4dB and isolation -21.4dB, thus insertion loss has been improved to a great extent.

By the way, the present invention is not limited to the preferred embodiments mentioned heretofore, but for example, the width of an ohmic electrode and the thickness of a semiconductor substrate may be modified appropriately so that ohmic electrode in transmission line should have necessary characteristic impedance.

And it may be possible to change FET with a diode. Namely, the source and drain of FET may be replaced with anode (or cathode) and cathode (or anode) of a diode, for example, in the top view in FIG. 1, the firs ohmic electrode 40 of the first FET and the first ohmic electrode 60 of the second FET may be replaced with anodes (or cathode) of diode, and the shared electrode 50 may be cathode (or anode). In this case, the gate electrodes 70 and 80 are unnecessary.

And moreover, the present invention may also be to other circuits equal with the equivalent circuit diagrams in FIG. 2, FIG. 5, FIG. 8, FIG. 11, and FIG. 13.

As described heretofore, according to the present invention, it is possible to provide a semiconductor device that has a structure wherein the width of a gate electrode inside of an active layer and the length of a first ohmic electrode and a second ohmic electrode that pinch the above gate electrode are longer than at least 1/16 of a wavelength of used microwave or millimeter-wave, and the above ohmic electrode is made so as to function as a distributed-constant line, as a result, it is possible to satisfy the requirements to attain a large power transmission especially at a high frequency such as millimeter-wave or so, and a low insertion loss and a high isolation in a wide band, which has so far never been realized in the conventional semiconductor devices.

**Claims**

1. A semiconductor device having a semiconductor switch structure, comprising:

   - a plurality of circuits, wherein each circuit includes a field effect transistor (Q) and a first transmission line (100; 330; 480; 580),

   said plurality of circuits being electrically connected by
   connection of a first ohmic electrode (40, 60; 120, 130; 150; 210; 260; 350, 360; 410, 430; 510, 530) of said field effect transistor (Q) in a circuit via said first transmission line (100; 330; 480; 580) to the corresponding first electrode of the field effect transistor in the neighboring circuit, wherein said first transmission line (100; 330; 480; 580) linearly extends over said first ohmic electrode, and said first transmission line (100; 330; 480; 580) is connected to a first signal input/output terminal (10),
   connection of a second ohmic electrode (50; 160; 220; 270; 370; 420; 520) of said field effect transistor (Q) in a circuit to the corresponding second electrode of the field effect transistor in the neighboring circuit via a second transmission line (110; 340; 490; 590) or to a common ground potential, wherein said second transmission line (110; 340; 490; 590) extends linearly over the second ohmic electrode (50; 160; 220; 270; 370; 420; 520), and said second transmission line is connected to a second signal input/output terminal (20) or is grounded; and

   - connection of the gate electrode of said field effect transistor (Q) in a circuit to the corresponding gate electrode of the field effect transistor (Q) in the neighboring circuit extending linearly to a common gate potential Vg;

   **characterized in that**

   - a total length of said first transmission line (100; 330; 480; 580) of a plurality of said circuits as well as a total length of said second transmission line (110; 340; 490; 590) and of a total length of the gate electrode, in the longer direction, of the field effect transistor (Q) in each circuit is longer than at least 1/16 of propagation wavelength of microwave or millimeter-wave signals, operative with said semiconductor device, whereby said transmission line is a distributed-constant line.

2. A semiconductor device as set forth in claim 1, wherein said circuits comprise:

   - two pieces of field effect transistors (Q) whose drains are connected to each other,
   - two first transmission lines (100) that are connected respectively to sources of said two pieces of field effect transistors (Q), and
   - said second transmission line (110) that is connected to drains of said two pieces of field effect transistors (Q), whereby:
   - said first transmission lines (100) and said second transmission line (110) in said respective circuits are connected in serial respectively,
   - gates of said two field effect transistors (Q) are connected in common to gates of field transistor in other above circuits that are connected respectively by said first transmission lines (100),
   - in said circuits positioned at one end of said arrangement, the line ends of said serially connected two said first transmission lines (100) that are not connected to said field effect transistor (Q) is set as said first input/output terminal (10),
   - in said circuits positioned at the other end said arrangement, the line end of said serially connected said second transmission line (110) that is not connected to said field effect transistor is set as said second input/output terminal (20), and further
   - the total length of said plural first transmission lines (100) connected in serial as well as the total length of said plural second transmission lines (110) connected in serial and the total length of the gate electrodes, in the longer direction, of the field effect transistors are set to be longer than 1/16 of signals that said first and second input/output terminals (10, 20) input and output.

3. A semiconductor device as set forth in claim 1, wherein said circuits comprise:

   - field effect transistors (Q1~Qn) whose sources are grounded,

- transmission lines (190) that are connected to drains of said field effect transistors (Q1~Qn), whereby:

- said transmission lines (190) in the said respective circuits are connected in serial respectively,
- gates of said field effect transistors (Q1~Qn) are connected in common to gates of field transistor in other above circuits,
- in said circuits positioned at one end of the arrangement of said circuit, the line ends of said serially connected to said transmission line (190) that are not connected to said field effect transistor (Q1~Qn) is set as said first input/output terminal (10),
- in said circuits positioned at the other end of said arrangement, the line ends of said serially connected to said transmission line (190) that are not connected to said field effect transistor (Q1~Qn) is set as said second input/output terminal (20),
- the total length of said plural transmission lines (190) connected in serial are set to be longer than 1/16 of the propagation wavelength of signals that said first and second input/output terminals (10, 20) input and output.

4. A semiconductor device as set forth in claim 1, wherein said circuits comprise:

- a first field effect transistor (Q11~Q1n),
- a first transmission line (330) that is connected to the source of said first field effect transistor (Q11~Q1n),
- a second transmission line (340) that is connected to the drain of said first field effect transistor (Q11~Q1n),
- a second field effect transistor (Q21~Q2n) whose drain is connected to the drain of said first field effect transistor (Q11~Q1n) and said second transmission line (340), and whose source is grounded, whereby:

- said first transmission line (330) and said second transmission line (340) in said respective circuits are connected in serial respectively,
- gates of said first field effect transistor (Q11~Q1n) are connected in common to each other, while gates of said second field effect transistor (Q21~Q2n) are connected in common to each other,
- in said circuits positioned at one end of the arrangement of said circuit, the line ends of said serially connected said first transmission line (330) that are not connected to said first field effect transistor (Q11~Q1n) is set as said first input/output terminal (10),
- in said circuits positioned at the other end of said arrangement, the line end of said serially connected to said second transmission line (340) that is not connected to said field effect transistor (Q11~Q1n) is set as said second input/output terminal (20), and
- the total length of said plural first transmission lines (330) connected in serial as well as the total length of said plural second transmission lines (340) connected in serial and the total length of the gate electrodes, in the longer direction, of the field effect transistors are set to be longer than 1/16 of the propagation wavelength of signals that said first and second input/output terminals (10, 20) input and output.

5. A semiconductor device as set forth in claim 4, wherein the second transmission line (340) that is connected to the drain of said first field effect transistor (Q11~Q1n) has an identical characteristic impedance to said first transmission line (330).

6. A semiconductor device as set forth in claim 1, wherein said circuits comprise:

- a first field effect transistor (Q11~Q1n),
- a first transmission line (580) that is connected to the source of said first field effect transistor (Q11~Q1n),
- a second transmission line (590) that is connected to the drain of said first field effect transistor (Q11~Q1n), and has a different characteristic impedance from said first transmission line (580),
- a second field effect transistor (Q21~Q2n) whose drain is connected to the drain of said first field effect transistor (Q11~Q1n) and said second transmission line (590), and whose source is grounded, wherein:
- said first transmission line (580) and said second transmission line (590) in respective circuits are connected in serial respectively,
- gates of said first field effect transistor (Q11~Q1n) are connected in common to each other, while gates of said second field effect transistor (Q21~Q2n) are connected in common to each other,
- in said circuits positioned at one end of the arrangement of said circuits, the line end of said serially connected to said first transmission (580) line that is not connected to said field effect transistor is set as said first input/output terminal (10),
- in said circuits positioned at the other end of said arrangement, the line end of said serially connected to said second transmission line (590) that is not connected to said field effect transistor is set as said second input/output terminal (20), and

- the total length of said plural first transmission lines (580) connected in serial as well as the total length of said plural second transmission lines (590) connected in serial and the total length of the gate electrodes, in the longer direction, of the field effect transistors are set to be longer than 1/16 of the propagation wavelength of signals that said first and second input/output terminals (10, 20) input and output.

7. A semiconductor device as set forth in claim 1, wherein:

- said circuits comprise a first circuit having two pieces of field effect transistors (Q11~Q1m, Q21~Q2m) and two transmission lines (480, 490), and a second circuit having one piece of field effect transistor (Q2m+1~Q2n) and a transmission line (490),
- said first circuit comprising:

  - a first field effect transistor (Q11~Q1m),
  - a first transmission line (480) that is connected to the source of said first field effect transistor (Q11~Q1m),
  - a second transmission line (490) that is connected to the drain of said first field effect transistor (Q11~Q1m), and has a different characteristic impedance from said first transmission line (480),
  - a second field effect transistor (Q21~Q2m) whose drain is connected to the drain of said first field effect transistor (Q11~Q1m) and said second transmission line (490), and whose source is grounded, whereby:
  - said second circuit comprises:

    - a field effect transistor (Q2m+1~Q2n) whose source is grounded,
    - a transmission line (490) that is connected to the drain of said field effect transistor,
    - the arrangement of said circuits is structured by a serial connection of the arrangement of said first circuit, and the arrangement of said second circuit, and whereby:

      - said first transmission line (480) and said second transmission line (490) in said first circuit are connected in serial respectively,
      - gates of said first field effect transistor (Q11~Q1m) are connected in common to each other, while gates of said second field effect transistor (Q21~Q2n) are connected in common to each other, and
      - said transmission line (490) in said second circuit are connected in serial respectively,
      - the gate of said field effect transistor (Q2m+1~Q2n) is connected in common to the gates in the other above second circuit, and
      - said second transmission line (490) of said first circuit positioned at one end of the arrangement of the first circuit is connected in serial to said second transmission line (490) of said second circuit positioned at the other end of said first circuit,
      - the gate of said second field effect transistor (Q21~Q2m) in said first circuit positioned at one end of the arrangement of said first circuit is connected in common with said field effect transistor (Q2m+1~Q2n) in said second circuit positioned at the other end of the arrangement of said second circuit,
      - in said circuits positioned at the end of the arrangement of said first circuit that is not connected to said second circuit, the line end of said serially connected said first transmission line (480) that is not connected to said field effect transistor is set as said first input/output terminal (10),
      - in said circuits positioned at the end the arrangement of said second circuit that is not connected to said first circuit, the line end of said serially connected said second transmission line (490) that is not connected to said field effect transistor is set as said second input/output terminal (20), and
      - the total length of said first transmission line (480) in the serially connected plural above first circuits and the second transmission line (490) in said second circuit as well as the total length of the gate electrodes, in the longer direction, of the field effect transistors is set to be longer than 1/16 of the propagation wavelength of signals that said first and second input/output terminals (10, 20) input and output.

8. A semiconductor device as set forth in claim 1, wherein:

- a desired number of circuits, comprising two pieces of field effect transistors (41, 61), wherein one of a pair of said first and second ohmic electrodes (40, 50; 60, 50) is set as a shared electrode (50), and covered with an active layer (30), are arranged at certain intervals so that said gate electrodes (70,80) should be arranged in a straight line, and corresponding above ohmic electrodes (40,50; 60,50) of neighboring above circuits are connected,

- one common end of two lines to which said ohmic electrodes (40,50; 60,50) that is not the shared electrode (50) are connected is set as said first input/output terminal (10);
- the other end of the line to which one of said ohmic electrodes (40,50; 60,50) that is the shared electrode (50) is connected is set as said second input/output terminal (20);
- said two gate electrodes (70,80) are pinched by the ohmic electrodes (40,50; 60,50) of said two field effect transistors are connected to each other outside of said active layer (30), and
- each length of said two gate electrodes (70,80) in said active layer (30), and the length of said respective lines connecting to said ohmic electrodes (40, 50; 60,50) are set to be longer than at least 1/16 of propagation wavelength of used microwave or millimeter wave.

9. A semiconductor device as set forth in claim 1, wherein:

- two pieces of field effect transistors covered with an active layer (30) are arranged wherein one of a pair of said first and second ohmic electrodes (120,50; 130,50) is set as a shared electrode (50),
- the ohmic electrode (120) that is not grounded and is not said shared electrode (50) is covered with the active layer (30) and is connected out of said active layer (30), and the connection point concerned is set as said first input/output terminal (10),
- the end opposite to said first input/output terminal (10) of the ohmic electrode that is said shared electrode (50) is set as said second input/output terminal (20),
- said two gate electrodes (70, 80) are pinched by said two ohmic electrodes (120, 130) of said field effect transistor, and are connected out of said active layer (30), and
- each length said two gate electrodes (70, 80) in said active layer (30), and the length of said ohmic electrodes (120,50; 130,50) are respectively set to be longer than at least 1/16 of propagation wavelength of used microwave or millimeter wave.

10. A semiconductor device as set forth in claim 1, wherein:

- a desired number of circuits, comprising field effect transistors having a pair of said first and second ohmic electrodes (150, 160) covered with an active layer (180), are arranged at certain intervals so that said gate electrodes (140) should be arranged in a straight line, and one of corresponding above ohmic electrodes (160) of neighboring above circuits is connected, while the other ohmic electrode (150) is grounded,
- one end of the line to which said ohmic electrodes (160) are connected is set as said first input/output terminal (10), while the other end is set as said second input/output terminal (20), and
- the length of said line connecting to said ohmic electrodes in said active layer is set to be longer than at least 1/16 of propagation wavelength of used microwave or millimeter wave.

11. A semiconductor device as set forth in claim 1, wherein:

- field effect transistors covered with an active layer (240) are arranged having a pair of said first and second ohmic electrodes (210, 220), and one of said ohmic electrodes (210) is grounded,
- one end of said ohmic electrode (220) that is not grounded is set as said first input/output terminal (10), while the other end is set as a second input/output terminal (20), and
- each of the length of said gate electrodes (200) in said active layer (240) and the length of the ohmic electrode (220) that is not grounded are set to be longer than at least 1/16 of propagation wavelength of used microwave or millimeter-wave.

12. A semiconductor device as set forth in claim 1, wherein:

- a desired number of circuits, comprising two pieces of field effect transistors (261, 281), wherein one of a pair of said first and second ohmic electrodes (260,270; 280,270) is set as a shared electrode (270), and covered with an active layer (320), are arranged at certain intervals so that said gate electrodes (290, 300) should be arranged in a straight line, ohmic electrodes that are said shared electrodes (270) among that corresponding above ohmic electrodes of neighboring above circuits are connected, while the other of ohmic electrodes (280) that are not said shared electrodes (270) are grounded,
- one end of the line to which said ohmic electrodes (260) are connected is set as said first input/output terminal (10),

- the other end opposite to said first input/output terminal (10) of the line to which the ohmic electrodes that are said shared electrodes (270) is set as said second input/output terminal (20), and
- each of the length of said two gate electrodes (290, 300), each of the length of said lines to which said ohmic electrodes (260,270; 280,270) are connected are set to be longer than at least 1/16 of propagation wavelength of used microwave or millimeter-wave.

**13.** A semiconductor device as set forth in claim 1, wherein:

- two pieces of field effect transistors covered with an active layer (400) are arranged wherein one of a pair of said first and second ohmic electrodes (350,370; 360,370) of one of said field effect transistors is set as a shared electrode (370), and one of said ohmic electrodes (360) is grounded,
- one end of said ohmic electrode (350) that is not said shared electrode (370) and is not grounded is set as said first input/output terminal (10),
- the end opposite to said first input/output terminal (10) of the ohmic electrode that is said shared electrode (370) is set as said second input/output terminal (20), and
- each of the length of said two gate electrodes (380, 390) in said active layer (400), and the length of each ohmic electrode (350,370; 360,370) are set to be longer than at least 1/16 of propagation wavelength of used microwave or millimeter-wave.

**14.** A semiconductor device as set forth in claim 1, wherein:

- two pieces of field effect transistors covered with an active layer (470) are arranged, wherein one of a pair of said first and second ohmic electrodes (410,420; 430,420) of one of said field effect transistors is set as a shared electrode (420), and one of said ohmic electrodes (430) is grounded,
- the length of said ohmic electrode (410) that is not said shared electrode (420) and is not grounded differs from the length of said other ohmic electrode (430), and the length of said gate electrode (450) differs from the length of other above gate electrode (460), whereby the gate electrode (450) is pinched by said ohmic electrode (410) that is not said shared electrode (430) and is not grounded and the ohmic electrode that is said shared electrode (420),
- one end of said ohmic electrode (410) that is not said shared electrode (420) and is not grounded is set as said first input/output terminal (10),
- the end opposite to said first input/output terminal (10) of the ohmic electrode that is said shared electrode (420) is set as said second input/output terminal (20), and
- each of the length of the ohmic electrode that is the shared electrode (420) in said active layer (470), the length of the ohmic electrode (430) that is grounded, and the length of one gate electrode (460) which is pinched by said pair of ohmic electrodes is set to be longer than at least 1/16 of propagation wavelength of used microwave or millimeter-wave.

**15.** A semiconductor device as set forth in claim 1, wherein:

- two pieces of field effect transistors covered with an active layer (470) are arranged, wherein one of a pair of said first and second ohmic electrodes (410,420; 430,420) of one of said field effect transistors is set as a shared electrode (420), and one of said ohmic electrodes (430) is grounded,
- the length of said ohmic electrode (410) that is not said shared electrode (420) and is not grounded is shorter than the length of said other ohmic electrode (430), and the length of said gate electrode (450) is shorter than the length of other above gate electrode (460), whereby said gate electrode (450) is pinched by said ohmic electrode (410) that is not said shared electrode (420) and is not grounded, and the ohmic electrode that is said shared electrode (420),
- one end of said ohmic electrode (410) that is not said shared electrode (420) and is not grounded is set as said first input/output terminal (10),
- the end opposite to said first input/output terminal (10) of the ohmic electrode that is said shared electrode (420) is set as said second input/output terminal (20), and
- each of the length of the ohmic electrode that is the shared electrode (420) in said active layer (470), the length of the ohmic electrode (430) that is grounded, and the length of one gate electrode (450) is pinched by said pair of ohmic electrodes is set to be longer than at least 1/16 of propagation wavelength of used microwave or millimeter-wave.

**16.** A semiconductor device as set forth in claim 1, wherein:

- two pieces of field effect transistors covered with an active layer (570) are arranged, wherein one of a pair of said first and second ohmic electrodes (510,520; 530,520) of one of said field effect transistors is set as a shared electrode (520), and one of said ohmic electrodes (530) is grounded,
- the width of said ohmic electrode (510) that is not said shared electrode (520) and is not grounded differs from the width of the ohmic electrode that is said shared electrode (520),
- one end of said ohmic electrode (510) that is not said shared electrode (520) and is not grounded is set as said first input/output terminal (10),
- the end opposite to said first input/output terminal (10) of the ohmic electrode that is said shared electrode (520) is set as said second input/output terminal (20), and
- each of the length of said two gate electrodes (550, 560) in said active layer (570), and length of each ohmic electrodes (510,520; 530,520) are set to be longer than at least 1/16 of propagation wavelength of used microwave or millimeter-wave.

**Patentansprüche**

1. Halbleitervorrichtung mit einem Halbleiterschaltaufbau, die Folgendes aufweist:

   - eine Vielzahl an Schaltkreisen, wobei jeder Schaltkreis einen Feldeffekttransistor (Q) und eine erste Übertragungsleitung (100; 330; 480; 580) aufweist,

   wobei die Vielzahl an Schaltkreisen elektrisch angeschlossen ist durch

   - Anschluss einer ersten ohmschen Elektrode (40, 60; 120, 130; 150; 210; 260; 350, 360; 410, 430; 510, 530) des Feldeffekttransistors (Q) in einem Schaltkreis über die erste Übertragungsleitung (100; 330; 480; 580) an die entsprechende erste Elektrode des Feldeffekttransistors im benachbarten Schaltkreis,

   wobei die erste Übertragungsleitung (100; 330; 480; 580) sich linear über die erste ohmsche Elektrode erstreckt, und die erste Übertragungsleitung (100; 330; 480; 580) an einen ersten Signal-Eingangs-/Ausgangsanschluss (10) angeschlossen ist,

   - Anschluss einer zweiten ohmschen Elektrode (50; 160; 220; 270; 370; 420; 520) des Feldeffekttransistors (Q) in einem - Schaltkreis über eine zweite Übertragungsleitung (110; 340; 490; 590) an die entsprechende zweite Elektrode des Feldeffekttransistors im benachbarten Schaltkreis oder an ein gemeinsames Erdpotential, wobei die zweite Übertragungsleitung (110; 340; 490; 590) sich linear über die zweite ohmsche Elektrode (50; 160; 220; 270; 370; 420; 520) erstreckt, und die zweite Übertragungsleitung an einen zweiten Signal-Eingangs-/Ausgangsanschluss (20) angeschlossen ist oder geerdet ist; und
   - Anschluss der Gateelektrode des Feldeffekttransistors (Q) in einem Schaltkreis an die entsprechende Gateelektrode des Feldeffekttransistors (Q) im benachbarten Schaltkreis, der sich linear zu einem gemeinsamen Gatepotential Vg erstreckt;

   **dadurch gekennzeichnet, dass**

   - eine Gesamtlänge der ersten Übertragungsleitung (100; 330; 480; 580) aus einer Vielzahl an Schaltkreisen sowie eine Gesamtlänge der zweiten Übertragungsleitung (110; 340; 490; 590) und einer Gesamtlänge der Gateelektrode in die längere Richtung des Feldeffekttransistors (Q) in jedem Schaltkreis länger als mindestens 1/16 der Ausbreitungswellenlänge der Mikrowellen- oder Millimeterwellensignale ist, welche betriebsbereit mit der Halbleitervorrichtung sind, wobei die Übertragungsleitung eine Konstant-Verteilungsleitung ist.

2. Halbleitervorrichtung nach Anspruch 1, **dadurch gekennzeichnet, dass** die Schaltkreise Folgendes aufweisen:

   - zwei Feldeffekttransistoren (Q), deren Drainanschlüsse aneinander angeschlossen sind,
   - zwei erste Übertragungsleitungen (100), die jeweils an die Sourceanschlüsse der zwei Feldeffekttransistoren (Q) angeschlossen sind, und
   - die zweite Übertragungsleitung (110), die an die Drainanschlüsse der beiden Feldeffekttransistoren (Q) angeschlossen ist, wobei:

     - die ersten Übertragungsleitungen (100) und die zweite Übertragungsleitung (110) in den jeweiligen Schaltkreisen jeweils in Reihe geschaltet sind,

- die Gateelektroden der zwei Feldeffekttransistoren (Q) mit den Gateelektroden des Feldeffekttransistors in den oben genannten anderen Schaltkreisen verbunden sind, die jeweils durch die ersten Übertragungsleitungen (100) angeschlossen sind,

- in diesen Schaltkreisen, die an einem Ende der Anordnung positioniert sind, das Leitungsende der in Reihe geschalteten zwei ersten Leitungen (100), die nicht an den Feldeffekttransistor (Q) angeschlossen sind, als der erste Eingangs-/Ausgangsanschluss (10) eingestellt ist,

- in diesen Schaltkreisen, die am anderen Ende der Anordnung positioniert sind, das Leitungsende der in Reihe geschalteten zweiten Leitung (110), die nicht an den Feldeffekttransistor (Q) angeschlossen ist, als der zweite Eingangs-/Ausgangsanschluss (20) festgelegt ist, und darüber hinaus

- die Gesamtlänge der Vielzahl an ersten Übertragungsleitungen (100), die in Reihe geschaltet sind, sowie die Gesamtlänge der Vielzahl an zweiten Übertragungsleitungen (110), die in Reihe geschaltet sind, und die Gesamtlänge der Gateelektroden in die längere Richtung der Feldeffekttransistoren so eingestellt sind, dass sie länger als 1/16 der Signale, die der erste und der zweite Eingangs-/Ausgangsanschluss (10, 20) eingeben und ausgeben, sind.

3.  Halbleitervorrichtung nach Anspruch 1, **dadurch gekennzeichnet, dass** die Schaltkreise Folgendes aufweisen:

- Feldeffekttransistoren (Q1~Qn), deren Sourceanschlüsse geerdet sind,

- Übertragungsleitungen (190), die an die Drainanschlüsse der Feldeffekttransistoren (Q1~Qn) angeschlossen sind, wobei:

- die Übertragungsleitungen (190) in den jeweiligen Schaltkreisen jeweils in Reihe geschaltet sind,

- Gatter der Feldeffekttransistoren (Q1~Qn) gemeinsam mit Gattern eines FET-Transistors in anderen, vorstehend genannten Schaltkreisen verbunden sind,

- in diesen Schaltkreisen, die an einem Ende der Schaltkreisanordnung positioniert sind, die Leitungsenden der in Reihe geschalteten Übertragungsleitungen (190), die nicht an den Feldeffekttransistor -(Q1~Qn) angeschlossen sind, als der erste Eingangs-/Ausgangsanschluss (10) festgelegt sind,

- in diesen Schaltkreisen, die am anderen Ende der Anordnung positioniert sind, die Übertragungsleitungsenden der in Reihe geschalteten Übertragungsleitungen (190), die nicht an den Feldeffekttransistor (Q1~Qn) angeschlossen sind, als der zweite Eingangs-/Ausgangsanschluss (20) festgelegt sind,

- die Gesamtlänge der Vielzahl an Übertragungsleitungen (190), die in Reihe geschaltet sind, länger als 1/16 der Ausbreitungswellenlänge der Signale sein muss, die die ersten und zweiten Eingangs-/Ausgangsanschlüsse (10, 20) eingeben und ausgeben.

4.  Halbleitervorrichtung nach Anspruch 1, **dadurch gekennzeichnet, dass** die Schaltkreise Folgendes aufweisen:

- einen ersten Feldeffekttransistor (Q11~Q1n),

- eine erste Übertragungsleitung (330), die an den Sourceanschluss des ersten Feldeffekttransistors (Q11~Q1n) angeschlossen ist,

- eine zweite Übertragungsleitung (340), die an den Drainanschluss des ersten Feldeffekttransistors (Q11~Q1n) angeschlossen ist,

- einen zweiten Feldeffekttransistor (Q21~Q2n), dessen Drainanschluss an den Drainanschluss des ersten Feldeffekttransistors (Q11~Q1n) und an die zweite Leitung (340) angeschlossen ist, und dessen Sourceanschluss geerdet ist, wobei:

- die erste Übertragungsleitung (330) und die zweite Übertragungsleitung (340) in den jeweiligen Schaltkreisen jeweils in Reihe geschaltet sind,

- Gatter des ersten Feldeffekttransistors (Q11~Q1n) miteinander verbunden sind, während die Gatter des zweiten Feldeffekttransistors (Q21~Q2n) miteinander verbunden sind sind,

- in diesen Schaltkreisen, die an einem Ende der Schaltkreisanordnung positioniert sind, die Übertragungsleitungsenden der in Reihe geschalteten ersten Übertragungsleitung (330), die nicht an den ersten Feldeffekttransistor (Q11~Q1n) angeschlossen sind, als der erste Eingangs-/Ausgangsanschluss (10) festgelegt sind,

- in diesen Schaltkreisen, die am anderen Ende der Anordnung positioniert sind, das Übertragungsleitungsende der in Reihe geschalteten zweiten Übertragungsleitung (340), das nicht an den Feldeffekttransistor (Q11~Q1n) angeschlossen ist, als der zweite Eingangs-/Ausgangsanschluss (20) festgelegt ist, und

- die Gesamtlänge der Vielzahl an ersten Übertragungsleitungen (330), die in Reihe geschaltet sind, sowie die Gesamtlänge der Anzahl an zweiten Übertragungsleitungen (340), die in Reihe geschaltet sind, und die Gesamtlänge der Gateelektroden in die längere Richtung der Feldeffekttransistoren länger als 1/16 der Ausbreitungswellenlänge der Signale sein muss, die der erste und zweite Eingangs-/Ausgangsanschluss (10, 20) eingeben und ausgeben.

5. Halbleitervorrichtung nach Anspruch 4, **dadurch gekennzeichnet, dass** die zweite Übertragungsleitung (340), die an den Drainanschluss des ersten Feldeffekttransistors (Q11~Q1n) angeschlossen ist, im Vergleich zur ersten Übertragungsleitung (330) einen identischen Kennwiderstand aufweist.

6. Halbleitervorrichtung nach Anspruch 1, **dadurch gekennzeichnet, dass** die Schaltkreise Folgendes aufweisen:

   - einen ersten Feldeffekttransistor (Q11~Q1n),
   - eine erste Übertragungsleitung (580), die an den Sourceanschluss des ersten Feldeffekttransistors (Q11~Q1n) angeschlossen ist,
   - eine zweite Übertragungsleitung (590), die an den Drainanschluss des ersten Feldeffekttransistors (Q11~Q1n) angeschlossen ist, und die im Vergleich zur ersten Übertragungsleitung (580) einen unterschiedlichen Kennwiderstand aufweist,
   - einen zweiten Feldeffekttransistor (Q21~Q2n), dessen Drainanschluss an den Drainanschluss des ersten Feldeffekttransistors (Q11~Q1n) und an die zweite Leitung (590) angeschlossen ist, und dessen Sourceanschluss geerdet ist, wobei:
   - die erste Übertragungsleitung (580) und die zweite Übertragungsleitung (590) in den jeweiligen Schaltkreisen jeweils in Reihe geschaltet sind,
   - die Gatter des ersten Feldeffekttransistors (Q11~Q1n) gemeinsam miteinander verbunden sind, während die Gatter des zweiten Feldeffekttransistors (Q21~Q2n) miteinander verbunden sind,
   - in diesen Schaltkreisen, die an einem Ende der Schaltkreisanordnung positioniert sind, das Übertragungsleitungsende der in Reihe geschalteten ersten Übertragungsleitung (580), die nicht an den Feldeffekttransistor angeschlossen ist, als der erste Eingangs-/Ausgangsanschluss (10) festgelegt ist,
   - in diesen Schaltkreisen, die am anderen Ende der Anordnung positioniert sind, das Übertragungsleitungsende der in Reihe geschalteten zweiten Übertragungsleitung (590), das nicht an den Feldeffekttransistor angeschlossen ist, als der zweite Eingangs-/Ausgangsanschlüss (20) festgelegt ist, und
   - die Gesamtlänge der Vielzahl an ersten Übertragungsleitungen (580), die in Reihe geschaltet sind, sowie die Gesamtlänge der Vielzahl an zweiten Übertragungsleitungen (590), die in Reihe geschaltet sind und die Gesamtlänge der Gatter in die längere Richtung des Feldeffekttransistors länger als 1/16 der Ausbreitungswellenlänge der Signale sein muss, die der erste und zweite Eingangs-/Ausgangsanschluss (10, 20) eingeben und ausgeben.

7. Halbleitervorrichtung nach Anspruch 1, **dadurch gekennzeichnet, dass**:

   - die Schaltkreise einen ersten Schaltkreis mit zwei Stück Feldeffekttransistoren (Q11~Q1m, Q21~Q2m) und zwei Übertragungsleitungen (480, 490) aufweisen, und einen zweiten Schaltkreis mit einem Feldeffekttransistor (Q2m+1~Q2n) und einer Übertragungsleitung (490),
   - wobei der erste Schaltkreis Folgendes aufweist:
   - einen ersten Feldeffekttransistor (Q11~Q1m),
   - eine erste Übertragungsleitung (480), die an den Sourceanschluss des ersten Feldeffekttransistors (Q11~Q1m) angeschlossen ist,
   - eine zweite Übertragungsleitung (490), die an den Drainanschluss des ersten Feldeffekttransistors (Q11~Q1m) angeschlossen ist, und die im Vergleich zu der ersten Übertragungsleitung (480) einen anderen Kennwiderstand aufweist,
   - einen zweiten Feldeffekttransistor (Q21~Q2m), dessen Drainanschluss an den Drainanschluss des ersten Feldeffekttransistors (Q11~Q1m) und an die zweite Übertragungsleitung (490) angeschlossen ist, und dessen Sourceanschluss geerdet ist, wobei:

       - der zweite Schaltkreis Folgendes aufweist:

           - einen Feldeffekttransistor (Q2m+1~Q2n), dessen Sourceanschluss geerdet ist,
           - eine Übertragungsleitung (490), die an den Drainanschluss des Feldeffekttransistors angeschlossen ist,
           - die Anordnung der Schaltkreise durch eine Reihenschaltung der Anordnung des ersten Schaltkreises und der Anordnung des zweiten Schaltkreises aufgebaut ist, und wobei:

               - die erste Übertragungsleitung (480) und die zweite Übertragungsleitung (490) in dem ersten Schaltkreis jeweils in Reihe geschaltet sind,

- die Gatter des ersten Feldeffekttransistors (Q11~Q1m) miteinander verbunden sind, während die Gatter des zweiten Feldeffekttransistors (Q21~Q2m) miteinander verbunden sind, und

- die Übertragungsleitung (490) in dem zweiten Schaltkreis jeweils in Reihe geschaltet ist,

- das Gatter des Feldeffekttransistors (Q2m+1~Q2n) mit den Gattern in dem anderen, oben genannten zweiten Schaltkreis verbunden ist, und

- die zweite Übertragungsleitung (490) des ersten Schaltkreises, der an einem Ende der Anordnung des ersten Schaltkreises positioniert ist, in Reihe geschaltet ist mit der zweiten Übertragungsleitung (490) des zweiten Schaltkreises, der am anderen Ende des ersten Schaltkreises positioniert ist,

- das Gatter des zweiten Feldeffekttransistors (Q21~Q2m) in dem ersten Schaltkreis, der an einem Ende der Anordnung des ersten Schaltkreises positioniert ist, mit dem Feldeffekttransistor (Q2m+1~Q2n) in dem zweiten Schaltkreis, der am anderen Ende der Anordnung des zweiten Schaltkreises positioniert ist, verbunden ist,

- in den Schaltkreisen, die am Ende der Anordnung des ersten Schaltkreises, der nicht an den zweiten Schaltkreis angeschlossen ist, positioniert sind, das Übertragungsleitungsende der ersten in Reihe geschalteten Übertragungsleitung (480), das nicht an den Feldeffekttransistor angeschlossen ist, als der erste Eingangs-/Ausgangsanschluss (10) festgelegt ist,

- in den Schaltkreisen, die am Ende der Anordnung des zweiten Schaltkreises, der nicht an den ersten Schaltkreis angeschlossen ist, positioniert sind, das Übertragungsleitungsende der zweiten in Reihe geschalteten Übertragungsleitung (490), das nicht an den Feldeffekttransistor angeschlossen ist, als der zweite Eingangs-/Ausgangsanschluss (20) festgelegt ist, und

- die Gesamtlänge der ersten Übertragungsleitung (480) in der oben genannten, in Reihe geschalteten Vielzahl an ersten Schaltkreisen und der zweiten Übertragungsleitung (490) in dem zweiten Schaltkreis sowie die Gesamtlänge der Gatter in die längere Richtung der Feldeffekttransistoren länger als 1/16 der Ausbreitungswellenlänge der Signale sein muss, die der erste und zweiten Eingangs-/Ausgangsanschluss (10, 20) eingeben und ausgeben.

8. Halbleitervorrichtung nach Anspruch 1, **dadurch gekennzeichnet, dass**:

- eine gewünschte Anzahl an Schaltkreisen, die zwei Stück Feldeffekttransistoren (41, 61) aufweisen, wobei eine aus einem Paar erster und zweiter ohmscher Elektroden (40, 50; 60, 50) als eine Gemeinschaftselektrode (50) festgelegt ist, und mit einer aktiven Schicht (30) überzogen ist, an bestimmten Intervallen so angeordnet sind, dass die Gatter (70, 80) in einer geraden Linie angeordnet sind, und entsprechende oben genannte ohmsche Elektroden (40, 50; 60, 50) oben genannter, benachbarter Schaltkreise verbunden sind,

- ein gemeinsames Ende von zwei Übertragungsleitungen, an das die ohmschen Elektroden (40, 50; 60, 50), die nicht die Gemeinschaftselektrode (50) bilden, angeschlossen sind, als der erste Eingangs-/Ausgangsanschluss (10) festgelegt;

- das andere Ende der Übertragungsleitung, an das eine der ohmschen Elektroden (40, 50; 60, 50), die die Gemeinschaftselektrode (50) ist, als der zweite Eingangs-/Ausgangsanschluss (20) festgelegt ist;

- die zwei Gateelektroden (70, 80) durch die ohmschen Elektroden (40, 50; 60, 50) der zwei Feldeffekttransistoren, die außerhalb der aktiven Schicht (30) aneinander angeschlossen sind, abgeklemmt werden, und

- jede Länge der zwei Gateelektroden (70, 80) in der aktiven Schicht (30), und die Länge der jeweiligen Übertragungsleitungen, die an die ohmschen Elektroden (40, 50; 60, 50) angeschlossen sind, länger als mindestens 1/16 der Ausbreitungswellenlänge der benutzten Mikrowelle oder Millimeterwelle sein muss.

9. Halbleitervorrichtung nach Anspruch 1, **dadurch gekennzeichnet, dass**:

- zwei Stück Feldeffekttransistoren, die mit einer aktiven Schicht (30) überzogen sind, so angeordnet sind, dass eine von den zwei ersten und zweiten ohmschen Elektroden (120, 50; 130, 50) als Gemeinschaftselektrode (50) festgelegt ist,

- die ohmsche Elektrode (120), die nicht geerdet ist und nicht die Gemeinschaftselektrode (50) ist, mit einer aktiven Schicht (30) überzogen ist und aus der aktiven Schicht (30) verbunden ist, und der betroffene Verbindungspunkt als der erste Eingangs-/Ausgangsanschluss (10) festgelegt ist,

- das Ende, das dem ersten Eingangs-/Ausgangsanschluss (10) der ohmschen Elektrode gegenüberliegt, die die Gemeinschaftselektrode (50) ist, als der zweite Eingangs-/Ausgangsanschluss (20) festgelegt ist,

- die zwei Gateelektroden (70, 80) durch die zwei ohmschen Elektroden (120, 130) des Feldeffekttransistors abgeklemmt werden, und außerhalb der aktiven Schicht (30) verbunden werden, und

- jede Länge der zwei Gateelektroden (70, 80) in der aktiven Schicht (30), und die Länge der ohmschen Elektroden (120, 50; 130, 50) jeweils länger als mindestens 1/16 der Ausbreitungswellenlänge der benutzten Mikrowelle oder Millimeterwelle sein muss.

**10.** Halbleitervorrichtung nach Anspruch 1, **dadurch gekennzeichnet, dass**:

- eine gewünschte Anzahl an Schaltkreisen, die Feldeffekttransistoren aufweisen, die zwei erste und zweite ohmsche Elektroden (150, 160) haben, die mit einer aktiven Schicht (180) überzogen sind, an bestimmten Intervallen so angeordnet sind, dass die Gateelektroden (140) in einer geraden Linie angeordnet sind, und eine entsprechende oben genannte ohmsche Elektrode (160) der benachbarten oben genannten Schaltkreise angeschlossen ist, während die andere ohmsche Elektrode (150) geerdet ist,
- ein Ende der Übertragungsleitung, an das die ohmschen Elektroden (160) angeschlossen sind, als der erste Eingangs-/Ausgangsanschluss (10) festgelegt, während das andere Ende als der zweite Eingangs-/Ausgangsanschluss (20) festgelegt ist, und
- die Länge der Übertragungsleitung, die mit den ohmschen Elektroden in der aktiven Schicht verbunden ist, länger als mindestens 1/16 der Ausbreitungswellenlänge der benutzten Mikrowelle oder Millimeterwelle sein muss.

**11.** Halbleitervorrichtung nach Anspruch 1, **dadurch gekennzeichnet, dass**:

- Feldeffekttransistoren, welche mit einer aktiven Schicht (240) bedeckt sind, so angeordnet sind, dass sie ein Paar erster und zweiter ohmscher Elektroden (210, 220) aufweisen, und dass eine der ohmschen Elektroden (210) geerdet ist,
- ein Ende der nicht geerdeten ohmschen Elektrode (220) als der erste Eingangs-/Ausgangsanschluss (10) festgelegt ist, während das andere Ende als zweiter Eingangs-/Ausgangsanschluss (20) festgelegt ist, und
- alle Längen der Gateelektroden (200) in der aktiven Schicht (240) und die Länge der nicht geerdeten ohmschen Elektrode (220) so festgelegt sind, dass sie länger als mindestens 1/16 der Ausbreitungswellenlänge einer verwendeten Mikrowelle oder Millimeterwelle sind.

**12.** Halbleitervorrichtung nach Anspruch 1, **dadurch gekennzeichnet, dass**:

- eine gewünschte Anzahl an Schaltkreisen, die zwei Stück Feldeffekttransistoren (261, 281) aufweisen, wobei eine von den zwei ersten und zweiten ohmschen Elektroden (260, 270; 280, 270) als Gemeinschaftselektrode (270) eingestellt und mit einer aktiven Schicht (320) überzogen ist, an bestimmten Intervallen so angeordnet sind, dass die Gateelektroden (290, 300) in einer geraden Linie angeordnet sind, ohmsche Elektroden, die die Gemeinschaftselektroden (270) unter den entsprechenden oben genannten ohmschen Elektroden der benachbarten oben genannten Schaltkreise sind, angeschlossen sind, während die andere der ohmschen Elektroden (280), die nicht die Gemeinschaftselektroden (270) sind, geerdet sind,
- ein Ende der Übertragungsleitung, an das die ohmschen Elektroden (260) angeschlossen sind, als der erste Eingangs-/Ausgangsanschluss (10) festgelegt ist,
- das andere Ende der Übertragungsleitung, das dem ersten Eingangs-/Ausgangsanschluss (10) gegenüberliegt, an das die ohmschen Elektroden, die die Gemeinschaftselektroden (270) sind, angeschlossen sind, als der zweite Eingangs-/Ausgangsanschluss (20) festgelegt ist, und
- jede der Längen der zwei Gateelektroden (290, 300), jede der Längen der Übertragungsleitungen, an die die ohmschen Elektroden (260, 270; 280, 270) angeschlossen sind, länger als mindestens 1/16 der Ausbreitungswellenlänge der benutzten Mikrowelle oder Millimeterwelle sein muss.

**13.** Halbleitervorrichtung nach Anspruch 1, **dadurch gekennzeichnet, dass**:

- zwei Stück Feldeffekttransistoren, die mit einer aktiven Schicht (400) überzogen sind, so angeordnet sind, dass eine der beiden ersten und zweiten ohmschen Elektroden (350, 370; 360, 370) von einem der beiden Feldeffekttransistoren als Gemeinschaftselektrode (370) festgelegt ist, und eine der beiden ohmschen Elektroden (360) geerdet ist,
- ein Ende der ohmschen Elektrode (350), die nicht die Gemeinschaftselektrode (370) ist und nicht geerdet ist, als der erste Eingangs-/Ausgangsanschluss (10) festgelegt ist,
- das Ende, das dem ersten Eingangs-/Ausgangsanschluss (10) der ohmschen Elektrode, die die Gemeinschaftselektrode (370) ist, gegenüberliegt, als der zweite Eingangs-/Ausgangsanschluss (20) festgelegt ist, und
- jede der Längen der zwei Gateelektroden (380, 390) in der aktiven Schicht (400), und die Länge einer jeden ohmschen Elektrode (350, 370; 360, 370) länger als mindestens 1/16 der Ausbreitungswellenlänge der benutzten Mikrowelle oder Millimeterwelle sein muss.

**14.** Halbleitervorrichtung nach Anspruch 1, **dadurch gekennzeichnet, dass**:

- zwei Feldeffekttransistoren, die mit einer aktiven Schicht (470) überzogen sind, so angeordnet sind, dass eine der beiden ersten und zweiten ohmschen Elektroden (410, 420; 430, 420) von einem der beiden Feldeffekttransistoren als Gemeinschaftselektrode (420) festgelegt ist, und eine der beiden ohmschen Elektroden (430) geerdet ist,
- die Länge der ohmschen Elektrode (410), die nicht die Gemeinschaftselektrode (420) ist und nicht geerdet ist, sich von der Länge der anderen ohmschen Elektroden (430) unterscheidet, und die Länge der Gateelektrode (450) sich von der Länge der anderen oben genannten Gateelektrode (460) unterscheidet, wobei die Gateelektrode (450) durch die ohmsche Elektrode (410), die nicht die Gemeinschaftselektrode (430) ist und nicht geerdet ist, und der ohmschen Elektrode, die die Gemeinschaftselektrode (420) ist, abgeklemmt ist,
- ein Ende der ohmschen Elektrode (410), die nicht die Gemeinschaftselektrode (420) ist und nicht geerdet ist, als der erste Eingangs-/Ausgangsanschluss (10) festgelegt ist,
- das Ende, das dem ersten Eingangs-/Ausgangsanschluss (10) der ohmschen Elektrode, die die Gemeinschaftselektrode (420) ist, gegenüberliegt, als der zweite Eingangs-/Ausgangsanschluss (20) festgelegt ist, und
- jede der Längen der ohmschen Elektrode, die die Gemeinschaftselektrode (420) in der aktiven Schicht (470) ist, die Länge der ohmschen Elektrode (430), die geerdet ist, und die Länge einer Gateelektrode (460), die durch das Paar ohmscher Elektroden abgeklemmt ist, so eingestellt sind, dass sie länger als mindestens 1/16 der Ausbreitungswellenlänge der benutzten Mikrowelle oder Millimeterwelle sein müssen.

**15.** Halbleitervorrichtung nach Anspruch 1, **dadurch gekennzeichnet, dass**:

- zwei Stück Feldeffekttransistoren, die mit einer aktiven Schicht (470) überzogen sind, so angeordnet sind, dass eine der beiden ersten und zweiten ohmschen Elektroden (410, 420; 430, 420) eines der Feldeffekttransistoren als Gemeinschaftselektrode (420) eingestellt ist, und eine der beiden ohmschen Elektroden (430) geerdet ist,
- die Länge der ohmschen Elektrode (410), die nicht die Gemeinschaftselektrode (420) ist und nicht geerdet ist, kürzer als die Länge der anderen ohmschen Elektrode (430) ist, und die Länge der Gateelektrode (450) kürzer als die Länge der anderen, oben genannten Gateelektrode (460) ist, wobei die Gateelektrode (450) durch die ohmsche Elektrode (410), die nicht die Gemeinschaftselektrode (420) ist und nicht geerdet ist, und durch die ohmsche Elektrode, die die Gemeinschaftselektrode (420) ist, abgeklemmt ist,
- ein Ende der ohmschen Elektrode (410), die nicht die Gemeinschaftselektrode (420) ist und nicht geerdet ist, als der erste Eingangs-/Ausgangsanschluss (10) eingestellt ist,
- das Ende, das dem ersten Eingangs-/Ausgangsanschluss (10) der ohmschen Elektrode, die die Gemeinschaftselektrode (420) ist, gegenüberliegt, als der zweite Eingangs-/Ausgangsanschluss (20) eingestellt ist, und
- jede der Längen der ohmschen Elektrode, die die Gemeinschaftselektrode (420) in der aktiven Schicht (470) ist, die Länge der ohmschen Elektrode (430), die geerdet ist, und die Länge einer Gateelektrode (450), die durch die ohmschen Elektroden abgeklemmt ist, so festgelegt sind, dass sie länger als mindestens 1/16 der Ausbreitungswellenlänge der benutzten Mikrowelle oder Millimeterwelle sind.

**16.** Halbleitervorrichtung nach Anspruch 1, **dadurch gekennzeichnet, dass**:

- zwei Stück Feldeffekttransistoren, die mit einer aktiven Schicht (570) überzogen sind, so angeordnet sind, dass eine der beiden ersten und zweiten ohmschen Elektroden (510, 520; 530, 520) von einem der Feldeffekttransistoren als Gemeinschaftselektrode (520) eingestellt ist, und eine der ohmschen Elektroden (530) geerdet ist,
- die Breite der ohmschen Elektrode (510), die nicht die Gemeinschaftselektrode (520) ist und nicht geerdet ist, sich von der Breite der ohmschen Elektrode, die die Gemeinschaftselektrode (520) ist, unterscheidet,
- ein Ende der ohmschen Elektrode (510), die nicht die Gemeinschaftselektrode (520) ist und nicht geerdet ist, als der erste Eingangs-/Ausgangsanschluss (10) eingestellt ist,
- das Ende, das dem ersten Eingangs-/Ausgangsanschluss (10) der ohmschen Elektrode, die die Gemeinschaftselektrode (520) ist, gegenüberliegt, als der zweite Eingangs-/Ausgangsanschluss (20) eingestellt ist, und
- jede der Längen der zwei Gateelektroden (550, 560) in der aktiven Schicht (570), und die Länge einer jeden ohmschen Elektrode (510, 520; 530, 520) so eingestellt sind, dass sie länger als mindestens 1/16 der Ausbreitungswellenlänge der benutzten Mikrowelle oder Millimeterwelle sind.

**Revendications**

1. Un dispositif de semi-conducteur ayant une structure de commutateur de semi-conducteur, qui présente:

   - une pluralité de circuits, où chaque circuit inclut un transistor à effet de champ (Q) et une première ligne de transmission (100; 330; 480; 580), ladite pluralité de circuits connectée étant connecté électriquement par

   la connexion d'une première électrode ohmique (40, 60; 120. 130; 150; 210; 260; 350, 360; 410, 430; 510, 530) dudit transistor à effet de champ (Q) dans un circuit par l'intermédiaire de ladite première ligne de transmission (100; 330; 480; 580) à la première électrode correspondante du transistor à effet de champ dans le circuit voisin, où ladite première ligne de transmission (100; 330; 480; 580) s'étend linéairement par ladite première électrode ohmique et ladite première ligne de transmission (100; 330; 480; 580) est connectée à un premier terminal d'entrée/sortie de signal (10),
   la connexion d'une deuxième électrode ohmique (50; 160; 220; 270; 370; 420; 520) dudit transistor à effet de champ (Q) dans un circuit à la deuxième électrode correspondante du transistor à effet de champ dans le circuit voisin par l'intermédiaire d'une deuxième ligne de transmission (110; 340; 490; 590) ou à un potentiel de la terre commune, où ladite deuxième ligne de transmission (110; 340; 490; 590) s'étend linéairement sur la deuxième électrode ohmique (50; 160; 220; 270; 370; 420; 520), et ladite deuxième ligne de transmission est connectée à un deuxième terminal dentrée/sortie de signal (20) ou est mise à la terre; et

   - connexion du portillon dudit transistor à effet de champ (Q) dans un circuit au portillon correspondant du transistor à effet de champ (Q) dans le circuit voisin s'étendant linéairement à un potentiel de grille commune Vg;

   **caractérisé en ce**
   **qu'**une longueur totale de ladite première ligne de transmission (100; 330; 480; 580) d'une pluralité desdits circuits ainsi qu'une longueur totale de ladite deuxième ligne de transmission (110; 340; 490; 590) et d'une longueur totale du portillon, dans le sens plus long du transistor à effet de champ (Q), dans chaque circuit, est plus longue qu'au moins 1/16 de la longueur d'onde de propagation des signaux à micro-ondes ou à ondes millimétriques; employé avec ledit dispositif de semi-conducteur,
   où ladite ligne de transmission est une ligne à constante distribuée.

2. Un dispositif de semi-conducteur selon la revendication 1, où lesdits circuits présentent:

   - deux pièces de transistors à effet de champ (Q), dont les drains sont connectés entre eux,
   - deux premières lignes de transmission (100) qui sont connectées respectivement aux sources desdits deux pièces de transistors à effet de champ (Q), et
   - ladite deuxième ligne de transmission (110) qui est connectée aux drains desdits deux pièces de transistors à effet de champ (Q), où:

      - ladite première ligne de transmission (100) et ladite deuxième ligne de transmission (110) dans lesdits circuits respectifs sont connectées en série respectivement,
      - des grilles desdits deux transistors à effet de champ (Q) sont connectées en commun aux grilles de transistors à effet de champ dans d'autres circuits au-dessus qui sont connectéées respectivement par lesdites premières lignes de transmission (100)
      - dans lesdits circuits fixés à une extrémité de ladite disposition, les extrémités des lignes desdites deux premières lignes de transmission (100) connectés en série qui ne sont pas connectées audit transistor à effet de champ (Q) sont fixées comme ledit premier terminal d'entrée/sortie (10),
      - dans lesdits circuits fixés à l'autre extrémité de ladite disposition, l'extrémité de ligne de ladite deuxième ligne de transmission connectée en série (110) qui nest pas connectée audit transistor à effet de champ est fixéée comme ledit deuxième terminal dentrée/sortie (20), et en outre.
      - la longueur totale de ladite pluralité de premières lignes de transmission (100) connectée en série ainsi que la longueur totale de ladite pluralité de deuxièmes lignes de transmission (110) connectées en série et la longueur totale des portillons, dans le sens plus long des transistors à effet de champ sont fixées pour êêtre plus longue que 1/16 des signaux que ledit premier et ledit deuxième terminal d'entrée/sortie (10, 20) entrent et sortent.

3. Un dispositif de semi-conducteur selon la revendication 1, où lesdits circuits présentent:

- des transistors à effet de champ (Q1-Qn) dont les sources sont mises à la terre,
- des lignes de transmission (190) qui sont connectées aux drains desdits transistors à effet de champ (Q1-Qn), ou:
- lesdites lignes de transmission (190) dans lesdits circuits respectifs sont connectées en série respectivement,
- des grilles desdits transistors à effet de champ (Q1-Qn) sont connectées en commun aux grilles du transistor de zone dans d'autres circuits au-dessus,
- dans lesdits circuits positionnés à une extrémité de la disposition dudit circuit, les extrémités des lignes de ladite connectées en série à ladite ligne de transmission (190), qui ne sont pas connectées audit transistor à effet de champ (Q1-Qn) sont fixées comme ledit premier terminal d'entrée/sortie (10),
- dans lesdits circuits positionnés à l'autre extrémité de ladite disposition, l'extrémité des lignes de ladite connectées en série à ladite ligne de transmission (190) qui ne sont pas connectées audit transistor à effet de champ (Q1-Qn) sont fixées comme ledit deuxième terminal d'entrée/sortie (20),
- la longueur totale de ladite pluralité de lignes de transmission (100) connectée en série est fixée pour être plus longue que 1/16 de la longueur d'onde de propagation des signaux que le premier et le deuxième terminal d'entrée/sortie (10, 20) entrent et sortent.

4. Un dispositif de semi-conducteur selon la revendication 1, où lesdits circuits présentent:

- un premier transistor à effet de champ (Q11-Q1n),
- une première ligne de transmission (330) qui est connectée à la source dudit premier transistor à effet de champ (Q11-Q1n),
- une deuxième ligne de transmission (340) qui est connectée au drain dudit premier transistor à effet de champ (Q11-Q1n),
- un deuxième transistor à effet de champ (Q21-Q2n) dont le drain est connecté au drain dudit premier transistor à effet de champ (Q11-Q1n) et de ladite deuxième ligne de transmission (340), et dont la source est mise à la terre, où:
- ladite première ligne de transmission (330) et ladite deuxième ligne de transmission (340) dans lesdits circuits respectifs sont connectées en série respectivement,
- des grilles dudit premier transistor à effet de champ (Q11-Q1n) sont connectées en commun entre eux, tandis que des grilles dudit deuxième transistor à effet de champ (Q21-Q2n) sont connectées en commun entre eux,
- dans lesdits circuits fixés à une extrémité de la disposition dudit circuit, les extrémités de ladite connectée en série à ladite première ligne de transmission (330) qui ne sont pas connectées audit premier transistor à effet de champ (Q11-Q1n) sont fixées comme ledit premier terminal d'entrée/sortie (10),
- dans lesdits circuits fixés à l'autre extrémité de ladite disposition, l'extrémité de la ligne de ladite deuxième ligne de transmission (340) connectée en série qui ne sont pas connectées audit transistor à effet de champ (Q11-Q1n) est fixée comme ledit deuxième terminal d'entrée/sortie (20), et
- la longueur totale de ladite pluralité de premières lignes de transmission (330) est connectée en série ainsi que la longueur totale de ladite pluralité de deuxièmes lignes de transmission (340) connectées en série et la longueur totale des portillons, dans le sens plus long des transistors à effet de champ de sont fixés pour être plus longs que 1/16 de la longueur d'onde de propagation des signaux que ledit premier et ledit deuxièème terminal d'entrée/sortie (10, 20) entrent et sortent.

5. Un dispositif de semi-conducteur selon la revendication 4, où la deuxième ligne de transmission (340) qui est connectée au drain dudit premier transistor à effet de champ (Q11-Q1n) a une impédance caractéristique identique à ladite première ligne de transmission (330).

6. Un dispositif de semi-conducteur selon la revendication 1, où lesdits circuits présentent:

- un premier transistor à effet de champ (Q11-Q1n),
- une première ligne de transmission (580) qui est connectée à la source dudit premier transistor à effet de champ (Q11-Q1n),
- une deuxième ligne de transmission (590) qui est connectées au drain dudit premier transistor à effet de champ (Q11-Q1n), et a une impédance caractéristique différente de ladite première ligne de transmission (580),
- un deuxième transistor à effet de champ (Q21wQ2n) dont le drain est connecté au drain dudit premier transistor à effet de champ (Q11-Q1n) et de ladite deuxième ligne de transmission (590), et dont la source est mise à la terre, où:
- ladite première ligne de transmission (580) et ladite deuxième ligne de transmission (590) dans des circuits respectifs sont connectées en série respectivement,

- des grilles dudit premier transistor à effet de champ (Q11-Q1n) sont connectées en commun entre eux, tandis que des grilles dudit deuxième transistor à effet de champ (Q21-Q2n) sont connectées en commun entre eux,
- dans lesdits circuits fixés à une extrémité de la disposition desdits circuits, l'extrémité de ladite ligne connectée en série à ladite première ligne de transmission (580) qui n'est pas connectée audit transistor à effet de champ est fixée comme ledit premier terminal d'entrée/sortie (10),
- dans lesdits circuits fixés à l'autre extrémité de ladite disposition, l'extrémité de ladite ligne connectée en série à ladite deuxième ligne de transmission (590) qui n'est pas connectée audit transistor à effet de champ est fixée comme ledit deuxième terminal dentrée/sortie (20), et
- la longueur totale de ladite pluralité de premières lignes de transmission (580) connectée en série ainsi que la longueur totale de ladite pluralité de deuxièmes lignes de transmission (590) connectées en série et la longueur totale des portillons, dans le sens plus long des transistors à effet de champ sont fixés pour être plus longs que 1/16 de la longueur d'onde de propagation des signaux que ledit premier et ledit deuxième terminal d'entrée/sortie (10, 20) entrent et sortent.

7. Un dispositif de semi-conducteur selon la revendication 1, où

- lesdits circuits présentent un premier circuit ayant deux pièces de transistors à effet de champ (Q11-Q1m, Q21-Q2m) et deux lignes de transmission (480, 490), et un deuxième circuit ayant l'une seule pièce du transistor à effet de champ (Q2m+1-Q2n) et d'une ligne de transmission (490),
- ledit premier circuit présente:
- un premier transistor à effet de champ.(Q11-Q1m),
- une première ligne de transmission (480) qui est connectée à la source dudit premier transistor à effet de champ (Q11-Q1m),
- une deuxième ligne de transmission (490) qui est connectée au drain dudit premier transistor à effet de champ (Q11-Q1m), et a une impédance caractéristique différente de ladite première ligne de transmission (480),
- un deuxième transistor à effet de champ (Q21-Q2m) dont le drain est connecté au drain dudit premier transistor à effet de champ (Q11-Q1m) et de ladite deuxième ligne de transmission (490), et dont la source est mise à la terre, où:

- ledit deuxième circuit présente:

- un transistor à effet de champ (Q2m+1-Q2n) dont la source est mise à la terre,
- une ligne de transmission (490) qui est connectée au drain dudit transistor à effet dé champ,
- la disposition desdits circuits est structuré par une connexion séquentielle de la disposition dudit premier circuit, et la disposition dudit deuxième circuit, et où:

- ladite première ligne de transmission (480) et ladite deuxième ligne de transmission (490) dans ledit premier circuit sont connectées en série respectivement,
- des grilles dudit premier transistor à effet de champ (Q11-Q1m) sont connectés en commun entre eux, tandis que des grilles dudit deuxième transistor à effet de champ (Q21-Q2n) sont connectées en commun entre eux, et
- ladite ligne de transmission (490) dans ledit deuxième circuit sont connectées en série respectivement,
- la grille dudit transistor à effet de champ (Q2m+1-Q2n) est connectée en commun aux grilles dans l'autre deuxième circuit au-dessus, et
- ladite deuxième ligne de transmission (490) dudit premier circuit fixé à une extrémité de la disposition du premier circuit est connectée en série à ladite deuxième ligne de transmission (490) dudit deuxième circuit fixé à l'autre extrémité dudit premier circuit,
- la grille dudit deuxième transistor à effet de champ (Q21-Q2m) dans ledit premier circuit fixé à une extrémité de la disposition dudit premier circuit est connectée en commun avec le transistor à effet de champ (Q2m+1-Q2n) dans ledit deuxième circuit fixé à l'autre extrémité de la disposition dudit deuxième circuit,
- dans lesdits circuits fixés à l'extrémité de la disposition dudit premier circuit qui n'est pas connecté audit deuxième circuit, l'extrémité de la ligne de ladite première ligne de transmission (480) connectée en série qui n'est pas connectée audit transistor à effet de champ est fixée comme ledit premier terminal d'entrée/sortie (10),
- dans lesdits circuits fixés à l'extrémité de la disposition dudit deuxième circuit qui n'est pas connecté audit premier circuit, lextrémité de la ligne de ladite deuxième ligne de transmission (490) connectée en série qui ne sont pas connectées audit transistor à effet de champ est fixée comme ledit deuxième terminal d'entrée/sortie (20), et

- la longueur totale de ladite première ligne de transmission (480) dans la pluralité de premiers circuits connectés en série au-dessus et de la deuxième ligne de transmission (490) dans ledit deuxième circuit ainsi que la longueur totale des portillons, dans le sens plus long des transistors à effet de champ est fixée pour être plus longue que 1/16 de la longueur d'onde de propagation des signaux qui le premier et le deuxième terminal d'entrée/sortie (10, 20) entrent et sortent.

**8.** Un dispositif de semi-conducteur selon la revendication 1, où:

un nombre de circuits désiré, présentant deux pièces de transistors à effet de champ (41, 61), où lune d'une paire dudit premier et dudit deuxième électrodes ohmiques (40, 50; 60. 50) est fixée comme électrode partagée (50), et couvert dune couche active (30), sont disposés à certains intervalles de sorte que lesdits portillons (70,80) devraient être disposées en ligne droite, et des électrodes ohmiques correspondantes au-dessus (40, 50; 60, 50) des circuits voisin au-dessus sont connectés,

- une extrémité commune de deux lignes auxquelles lesdites électrodes ohmiques (40, 50; 60, 50), qui ne sont pas l'électrode partagée (50) sont connectées, est fixée comme ledit premier terminal d'entrée/sortie (10);
- l'autre extrémité de la ligne à laquelle lune desdites électrodes ohmiques (40, 50; 60, 50) qui est l'électrode partagée (50) est connectée, est fixé comme ledit deuxième terminal d'entrée/sortie (20);
- lesdits deux portillons (70,80) sont pincés par les électrodes ohmiques (40, 50; 60, 50) desdits deux transistors à effet de champ sont connectés entre eux en dehors de ladite couche active (30), et
- chaque longueur desdits deux portillons (70,80) dans ladite couche active (30), et la longueur desdites lignes respectives se connectant auxdites électrodes ohmiques (40, 50; 60,50) sont fixés pour être plus longues qu'au moins 1/16 de la longueur d'onde de propagation de la micro-onde ou onde millimétrique utilisée.

**9.** Un dispositif de semi-conducteur selon la revendication 1, où:

- deux pièces de transistors à effet de champ couverts d'une couche active (30) sont disposés où l'une d'une paire de ladite première et de ladite deuxième électrodes ohmiques (120, 50; 130, 50) est fixée comme électrode partagée (50),
- l'électrode ohmique (120) qui nest pas mise à la terre et nest pas ladite électrode partagée (50) est couverte de la couche active (30) et est connectée hors de ladite couche active (30), et le point de connexion concerné est fixé comme ledit premier terminal d'entrée/sortie (10),
- l'extrémité en face dudit premier terminal d'entrée/sortie (10) de l'électrode ohmique qui est ladite électrode partagée (50) est fixé comme ledit deuxième terminal d'entrée/sortie (20),
- lesdits deux portillons (70, 80) sont pincés par lesdites deux électrodes ohmiques (120, 130) dudit transistor à effet de champ, et sont connectés hors de ladite couche active (30), et
- la longueur de chacun desdits deux portillons (70, 80) dans ladite couche active (30), et la longueur desdites électrodes ohmiques (120,50; 130,50) est respectivement fixée pour être plus longue qu'au moins 1/16 de la longueur d'onde de propagation de la micro-onde ou de l'onde millimétrique utilisée.

**10.** Un dispositif de semi-conducteur selon la revendication 1, où:

- un nombre désiré de circuits, présentant des transistors à effet de champ ayant une paire de ladite première et ladite deuxième électrode ohmiques (150, 160) couvert dune couche active (180), sont disposés à certains intervalles de sorte que lesdits portillons (140) devraient être disposées en ligne droite, et l'une des électrodes ohmiques (160) correspondantes au-dessus des circuits voisins au-dessus est connectée, tandis que l'autre électrode ohmique (150) est mise à la terre,
- une extrémité de la ligne à laquelle lesdites électrodes ohmiques (160) sont connectées est fixée comme ledit premier terminal d'entrée/sortie (10), tandis que l'autre extrémité est fixée comme ledit deuxième terminal dentrée/sortie (20), et
- la longueur de ladite ligne se connectant auxdites électrodes ohmiques dans ladite couche active est fixée pour être plus longue qu'au moins 1/16 de la longueur d'onde de propagation de la micro-onde ou de l'onde millimétrique utilisée.

**11.** Un dispositif de semi-conducteur selon la revendication 1, où:

- des transistors à effet de champ couverts dune couche active (240) sont disposés ayant des paires desdites premières et desdites deuxièmes électrodes ohmiques (210, 220), et une de lesdites électrodes ohmiques (210) est mise à la terre,
- une extrémité de ladite électrode ohmique (220) qui nest pas mise à la terre est fixée comme ledit premier terminal d'entrée/sortie (10), tandis que l'autre extrémité est fixée comme un deuxième terminal d'entrée/sortie (20), et
- la longueur desdits portillons (200) dans ladite couche active (240) et la longueur de l'électrode ohmique (220) qui n'est pas mises à la terre sont fixées chacune pour être plus longues qu'au moins 1/16 de la longueur d'onde de propagation de la micro-onde ou de l'onde millimétrique utilisée.

**12.** Un dispositif de semi-conducteur selon la revendication 1, où:

- un nombre désiré de circuits, présentant deux pièces de transistors à effet de champ (261, 281), où l'une d'une paire de ladite première et de ladite deuxième électrode ohmique (260.270; 280,270) est fixée comme électrode partagée (270), et couvert d'une couche active (320), sont disposées à certains intervalles de sorte que lesdits portillons (290, 300) devraient être disposées en ligne droite, des électrodes ohmiques qui sont lesdites électrodes partagées (270) parmi les électrodes ohmiques au-dessus correspondantes des circuits voisins au-dessus sont connectées, tandis que les autres électrodes ohmiques (280) qui ne sont pas lesdites électrodes partagées (270) sont mises à la terre,
- une extrémité de la ligne à laquelle lesdites électrodes ohmiques (260) sont connectées est fixée comme ledit premier terminal d'entrée/sortie (10),
- l'autre extrémité en face dudit premier terminal d'entrée/sortie (10) de la ligne à laquelle les électrodes ohmiques qui sont lesdites électrodes partagées (270) sont connectées, est fixée comme ledit deuxième terminal dentrée/sortie (20), et
- la longueur de chacun desdits deux portillons (290, 300), la longueur de chacune desdites lignes auxquelles lesdites électrodes ohmiques (260,270; 280,270) sont connectées sont fixés pour être plus long qu'au moins 1/16 de la longueur d'onde de propagation de la micro-onde ou de l'onde millimétrique utilisée.

**13.** Un dispositif de semi-conducteur selon la revendication 1, où:

- deux pièces de transistors à effet de champ couverts d'une couche active (400) sont disposés, où l'une d'une paire de ladite première et de ladite deuxième électrodes ohmiques (350,370; 360,370) de l'un desdits transistors à effet de champ est fixée comme électrode partagée (370), et l'une desdites électrodes ohmiques (360) est mise à la terre,
- une extrémité de ladite électrode ohmique (350) qui n'est pas ladite électrode partagée (370) et n'est pas mise à la terre est fixée comme ledit premier terminal d'entrée/sortie (10),
- l'extrémité en face dudit premier terminal d'entrée/sortie (10) de l'électrode ohmique qui est ladite électrode partagée (370) est fixée comme ledit deuxième terminal d'entrée/sortie (20), et
- la longueur de chacun desdits deux portillons (290, 300), la longueur de chacune desdites lignes auxquelles lesdites électrodes ohmiques (260,270; 280,270) sont connectées sont fixés pour être plus long qu'au moins 1/16 de la longueur d'onde de propagation de la micro-onde ou de l'onde millimétrique utilisée.

**14.** Un dispositif de semi-conducteur selon la revendication 1, où:

- deux pièces de transistors à effet de champ couverts d'une couche active (470) sont disposés, où l'une d'une paire de ladite première et de ladite deuxième électrodes ohmiques (410, 420; 430, 420) de l'un desdits transistors à effet de champ est fixée comme électrode partagée (420), et l'une desdites électrodes ohmiques (430) est mise à la terre,
- la longueur de ladite électrode ohmique (410) qui nest pas ladite électrode partagée (420) et n'est pas mise à la terre diffère de la longueur de ladite autre électrode ohmique (430), et la longueur dudit portillon (450) diffère de la longueur d'autre portillon (460) au-dessus, où le portillon (450) est pincé par ladite électrode ohmique (410) qui nest pas ladite électrode partagée (430) et n'est pas mise à la terre et l'électrode ohmique qui est ladite électrode partagée (420),
- une extrémité de ladite électrode ohmique (410) qui nest pas ladite électrode partagée (420) et n'est pas mise à la terre est fixée comme ledit premier terminal d'entrée/sortie (10),
- l'extrémité en face dudit premier terminal d'entrée/sortie (10) de l'électrode ohmique qui est ladite électrode partagée (420) est fixée comme ledit deuxième terminal d'entrée/sortie (20), et
- la longueur de l'électrode ohmique qui est l'électrode partagée (420) dans ladite couche active (470), la longueur de l'électrode ohmique (430) qui est mise à la terre, et la longueur d'un portillon (460) qui est pincé par lesdites paires d'électrodes ohmiques sont fixées pour être plus longue qu'au moins 1/16 de la longueur d'onde de propagation de la micro-onde ou de l'onde millimétrique utilisée.

**15.** Un dispositif de semi-conducteur selon la revendication 1, où:

- deux pièces de transistors à effet de champ couverts d'une couche active (470) sont disposées, où l'une d'une paire de ladite première et de ladite deuxième électrodes ohmiques (410,420; 430,420) de l'une des transistors à effet de champ est fixé comme électrode partagée (420), et une desdites électrodes ohmiques (430) est mise à la terre,
- la longueur de ladite électrode ohmique (410) qui nest pas ladite électrode partagée (420) et n'est pas mise à la terre est plus courte que la longueur de ladite autre électrode ohmique (430), et la longueur dudit portillon (450) est plus courte que la longueur de l'autre portillon au-dessus (460), où ledit portillon (450) est pincée par ladite électrode ohmique (410) qui n'est pas ladite électrode partagée (420) et n'est pas mise à la terre, et l'électrode ohmique qui est ladite électrode partagée (420),
- une extrémité de ladite électrode ohmique (410) qui nest pas ladite électrode partagée (420) et n'est pas mise à la terre est fixée comme ledit premier terminal d'entrée/sortie (101),
- l'extrémité en face dudit premier terminal d'entrée/sortie (10) de l'électrode ohmique qui est ladite électrode partagée (420) est fixé comme ledit deuxième terminal d'entrée/sortie (20), et
- la longueur de l'électrode ohmique qui est l'électrode partagée (420) dans ladite couche active (470), la longueur de l'électrode ohmique (430) qui est mise à la terre, et la longueur d'un portillon (450) qui est pincé par lesdites paires d'électrodes ohmiques est fixée chacune pour être plus longue qu'au moins 1/16 de la longueur d'onde de propagation de la micro-onde ou de l'onde millimétrique utilisée.

**16.** Un dispositif de semi-conducteur selon la revendication 1, où:

- deux pièces de transistors à effet de champ couverts d'une couche active (570) sont disposés, où l'une d'une paire de ladite première et de ladite deuxième électrodes ohmiques (510,520; 530,520) de l'un desdits transistors à effet de champ est fixée comme électrode partagée (520), et l'une desdites électrodes ohmiques (530) est mise à la terre,
- la largeur de ladite électrode ohmique (510) qui nest pas ladite électrode partagée (520) et n'est pas mise à la terre diffère de la largeur de l'électrode ohmique qui est ladite électrode partagée (520),
- une extrémité de ladite électrode ohmique (510) qui nest pas ladite électrode partagée (520) et n'est pas mise à la terre est fixée comme ledit premier terminal d'entrée/sortie (bas),
- l'extrémité en face dudit premier terminal d'entrée/sortie (10) de l'électrode ohmique qui est ladite électrode partagée (520) est fixé comme ledit deuxième terminal d'entrée/sortie (20), et
- la longueur de chacun desdits deux portillons (550, 560) dans ladite couche active (570), et la longueur de chacune des électrodes ohmiques (510,520; 530,520) sont fixées pour être plus longue qu'au moins 1/16 de la longueur d'onde de propagation de la micro-onde ou de l'onde millimétrique utilisée.

FIG.1

# FIG.2

EP 0 821 425 B1

# FIG.3

EP 0 821 425 B1

FIG.4

# FIG.5

FIG.5

FIG.6

FIG.7

# FIG.8

EP 0 821 425 B1

FIG.9

# FIG.10

EP 0 821 425 B1

# FIG.11

# FIG.12

EP 0 821 425 B1

# FIG.13

EP 0 821 425 B1

# FIG.14

# FIG.15

# FIG.16

# FIG.17

# FIG.18

# FIG.19

1901 FET

# FIG.20

TRANSPARENT POWER $|S_{21}|^2$ (dB)

OFF

OFF

Wg=1mm

Wg=100 $\mu$m

FREQUENCY(GHz)

# FIG.21
## (PRIOR ART)

2101 FET

# FIG.22
## (PRIOR ART)

# FIG.23
## (PRIOR ART)

2301 FET

2302 FET

# FIG.24
## (PRIOR ART)

TRANSPARENT POWER $|S_{21}|^2$ (dB)

FREQUENCY(GHz)

ON

ON

VII

V

VIII

OFF

OFF

VI

Wg=1mm

Wg=100 $\mu$m

# FIG.25
## (PRIOR ART)

2501 FET

2502 COIL

# FIG.26
## (PRIOR ART)

Wg=1mm

OFF

TRANSPARENT POWER $|S_{21}|^2$ (dB)

FREQUENCY(GHz)

# FIG.27
## (PRIOR ART)

2702   $\lambda/4$ LINE

2701  FET

# FIG.28
## (PRIOR ART)

Wg=1mm

ON

IX

X

OFF

TRANSPARENT POWER $|S_{21}|^2$ (dB)

0

-20

-40

0          50          100

FREQUENCY(GHz)

# FIG.29
## (PRIOR ART)

2901 FET

Wg=100 μm

~2902 FET

Wg=1mm

# FIG.30
## (PRIOR ART)

TRANSPARENT POWER $|S_{21}|^2$ (dB)

0

ON

-20

OFF

-40

0          50          100

FREQUENCY(GHz)